# EUROPEAN PATENT APPLICATION

(11) **EP 4 290 350 A1**
(43) Date of publication of application: **13.12.2023**
(21) Application number: 23716164.1
(22) Date of filing: 12.04.2023
(51) Int. Cl.: G06F 3/04842, G06F 3/0481, G06F 3/041, H10K 59/40, G06F 3/04817, G06F 1/16, G06F 3/04847, G06F 3/0485

(54) **ELECTRONIC DEVICE COMPRISING FLEXIBLE DISPLAY, AND METHOD FOR ADJUSTING SIZE OF DISPLAY IN ELECTRONIC DEVICE**

(30) Priority: 19.04.2022 KR 20220048397; 28.06.2022 KR 20220078681
(71) Applicant: Samsung Electronics Co., Ltd., Suwon-Si, Gyeonggi-do 16677 (KR)
(72) Inventor: KIM, Munhwi, Suwon-si, Gyeonggi-do 16677 (KR); KIM, Hyunjung, Suwon-si, Gyeonggi-do 16677 (KR); LEE, Songmin, Suwon-si, Gyeonggi-do 16677 (KR); LEE, Wonjun, Suwon-si, Gyeonggi-do 16677 (KR); HAN, Jiyoung, Suwon-si, Gyeonggi-do 16677 (KR)
(74) Representative: HGF
(86) International application number: PCT/KR2023/004956
(87) International publication number: WO 2023/204519

(57) **Abstract**

An electronic device according to various embodiments may include a first housing, a second housing, at least one processor, and a flexible display. Part of the flexible display may be configured to beinserted into or extended from the first housing according to driving of a driving module of the electronic device. The at least one processor may be configured to display at least one control button for changing a size of an exposed portion of the flexible display.

## Description

### [Technical Field]

Various embodiments relate to an electronic device including a flexible display and a method of adjusting the size of the display in the electronic device.

### [Background Art]

An electronic device, for example, a portable electronic device such as a smartphone, has been providing a gradually increasing number ofvarious services and additional functions. To increase the utilization of such electronic devices and satisfy the needs of various users, communication service providers or electronic device manufacturers are competitively developing electronic devices to provide various functions and differentiate them from other companies. Accordingly, various functions provided through the electronic device are also increasingly advanced.

As the demand for mobile communication and the integration level of electronic devices have increased, portability of electronic devices, such as smartphones, and convenience in using multimedia functions may be improved. For web surfing or a multimedia function, use of an electronic device displaying a larger screen may provide convenience to a user. Although the electronic device may be equipped with a larger display to output a larger screen, there may be limitations in increasing the size of the display in consideration of the portability of the electronic device. For example, a display using organic light emitting diodes or the like may secure the portability of the electronic device, while providing a larger screen. Even when it is manufactured to be fairly thin, the display using organic light emitting diodes (or the electronic device equipped with the display) may realize a stable operation. Therefore, the display may be mounted in a foldable, bendable, or rollable form in the electronic device.

### [Disclosure]

### [Technical Problem]

In an electronic device including a traditional bar-type display, the size of the physical display may not be changed. An application view may be executed as a pop-up view within a fixed display size or may be used by adjusting the size of a view window. In an electronic device including a newly released horizontally/vertically foldable display, a displayed application view may be changed along with a change in the size of the display from the front to the rear and from the rear to the front. Other pop-up views and multi-window operations are similar.

However, the use behaviors of anelectronic device including the new flexible (e.g., rollable) display may be different. The size of the electronic device may be changed by adjusting the height of the display by as much as a reduced size as well as by adjusting the view window size of an application using the dynamically changing physical display. The size of the electronic device may be decreased to a minimum size or increased to a maximum size according to a user's application use needs. For this operation, a physical button may be provided by default or an additional software (SW) control button may be additionally provided. That is, it is possible to adjust even the height of the electronic device, further from the existing use behavior of adjusting the size of an application window according to the user's needs. In this case, to allow more advanced adjustment, attributevaluesmay be defined according to the features of application-specific views, and the heights of the display may be defined by the values. Therefore, the electronic device including the flexible display may provide each of a plurality of views provided by an application to the user, while changing the size of the display.

However, since the sizeof the display is changed based on a user input to a physical button, a plurality of views provided by an application may be different in size, and thus the user should change the size of the display to a desired one, each time a view of the application is displayed.

Various embodiments relate to a method of adjusting the size of a display in an electronic device including a flexible display.

According to various embodiments, a method of automatically displaying or manually invoking a control buttonforchanginga display, when the display needs to be changed according to an attribute of an application view in an electronic device including a flexible display is described.

### [Technical Solution]

According to various embodiments, an electronic device may include a first housing, a second housing disposed to be movable with respect to the first housing and overlapping with at least part of the first housing, at least one processor, and a flexible display at least partially mounted on a surface of the second housing and at least partially exposed to an outside of the electronic device. Part of the flexible display may be configured to beinserted into or extended from the first housing according to driving of a driving module of the electronic device. The at least one processor may be configured to display an execution screen of an application on the flexible display, identify whether a size of an exposed portion of the flexible display and a specified size of the flexible display for the execution screen match, when the size of exposed portion of the flexible display and the specified size of the flexible display do not match, display at least one control button for changing the size of the exposed portion of the flexible display on the flexible display.

According to various embodiments, a method of adjusting a size of an exposed portion of a flexible display of an electronic device may include displaying an execution screen of an application on the flexible display, identifying whether a size of an exposed portion of the flexible display and a specified size of the flexible display for the execution screen match, and when the size of exposed portion of the flexible display and the specified size of the flexible display do not match, displaying at least one control button for changing the size of the exposed portion of the flexible display on the flexible display.

### [Advantageous Effects]

According to various embodiments, as a control buttonis provided to change the size of a display based on an attribute of each of a plurality of views included in an application in an electronic device including a flexible display, a user may directly set a desired display size or perform an intended operation.

### [Description of the Drawings]

FIG. 1A is a diagram illustrating a closed state of an electronic device according to various embodiments.
FIG. 1B is a diagram illustrating an open state of the electronic device of FIG. 1A.
FIG. 1C is a diagram illustrating the rear surface of the electronic device of FIG. 1A.
FIGS. 2A to 2C are diagrams illustrating states of an electronic device based on a state in which a display is inserted into or exposed from a housing in the electronic device according to various embodiments.
FIG. 3A is a block diagram illustrating an electronic device according to various embodiments.
FIG. 3B is a flowchart illustrating an operation of adjusting the size of a display in an electronic device according to various embodiments.
FIGS. 4A to 4E are diagrams illustrating an operation of adjusting the size of a display in an electronic device according to various embodiments.
FIGS. 5A to 5C are diagrams illustrating an operation of adjusting the size of a display in an electronic device according to various embodiments.
FIGS. 6A to 6C are diagrams illustrating an operation of adjusting the size of a display in an electronic device according to various embodiments.
FIGS. 7A to 7C are diagrams illustrating an operation of adjusting the size of a display in an electronic device according to various embodiments.
FIGS. 8A to 8F are diagrams illustrating an operation of adjusting the size of a display in an electronic device according to various embodiments.
FIGS. 9A to 9F are diagrams illustrating an operation of adjusting the size of a display in an electronic device according to various embodiments.
FIGS. 10A to 10C are diagrams illustrating an operation of adjusting the size of a display in an electronic device according to various embodiments.
FIGS. 11A to 11D are diagrams illustrating an operation of adjusting the size of a display in an electronic device according to various embodiments.
FIGS. 12A to 12C are diagrams illustrating an operation of adjusting the size of a display in an electronic device according to various embodiments.
FIGS. 13A to 13C are diagrams illustrating an operation of adjusting the size of a display in an electronic device according to various embodiments.
FIGS. 14A to 14C are diagrams illustrating an operation of adjusting the size of a display in an electronic device according to various embodiments.
FIGS. 15A to 15D are diagrams illustrating an operation of adjusting the size of a display in an electronic device according to various embodiments.
FIGS. 16A and 16B are diagrams illustrating an operation of adjusting the size of a display in an electronic device according to various embodiments.
FIGS. 17A to 17D are diagrams illustrating an operation of adjusting the size of a display in an electronic device according to various embodiments.
FIGS. 18A to 18C are diagrams illustrating an operation of adjusting the size of a display in an electronic device according to various embodiments.
FIGS. 19A to 19D are diagrams illustrating an operation of adjusting the size of a display in an electronic device according to various embodiments.
FIGS. 20A to 20D are diagrams illustrating an operation of adjusting the size of a display in an electronic device according to various embodiments.
FIG. 21 is a block diagram illustrating an electronic device in a network environment according to various embodiments.
FIG. 22 is a diagram illustrating a state in which a second display area of a display is accommodated in a housing according to various embodiments.
FIG. 23 is a diagram illustrating a state in which a second display area of a display is exposed to the outside of a housing according to various embodiments.
FIG. 24 is an exploded perspective view illustrating an electronic device according to various embodiments.
FIG. 25A is a diagram illustrating a cross section taken along line A-A' of FIG. 22 according to various embodiments.
FIG. 25B is a diagram illustrating a cross section taken along line B-B' of FIG. 23 according to various embodiments.

### [Mode for Invention]

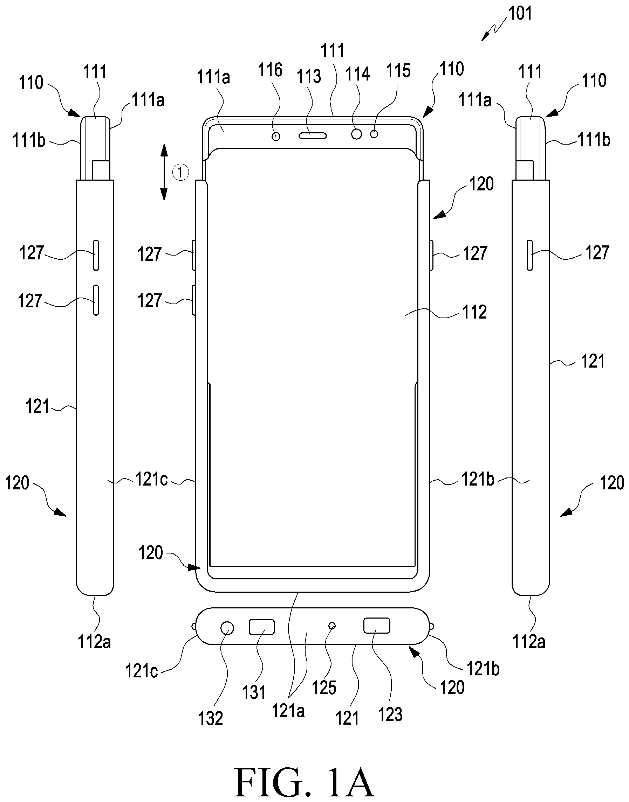

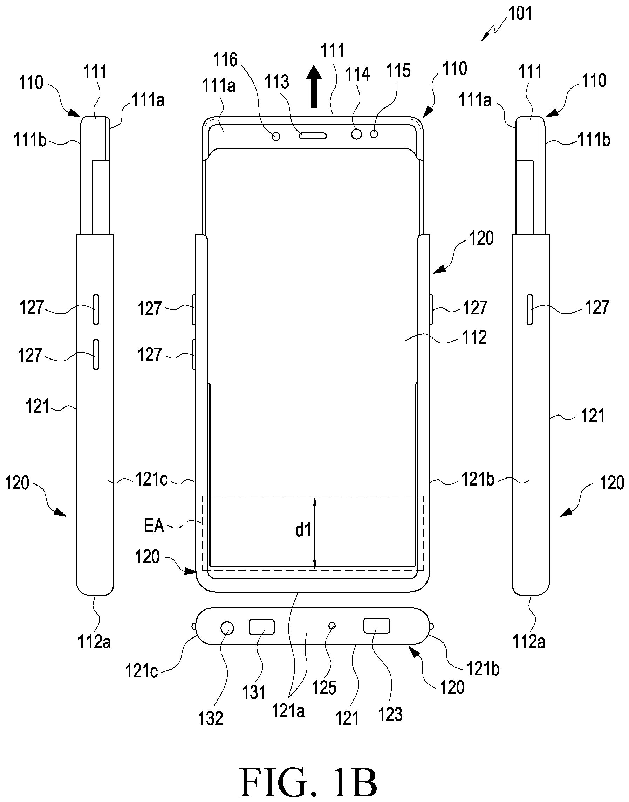

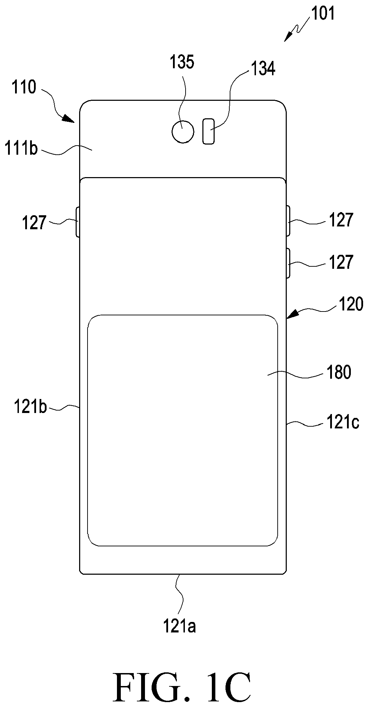

FIG. 1A is a diagram illustrating a closed state of an electronic device 101 according to various embodiments of the disclosure. FIG. 1B is a diagram illustrating an open state of the electronic device 101 of FIG. 1A. FIG. 1C is a diagram illustrating the rear surface of the electronic device 101 of FIG. 1A.

FIG. 1A illustrates a state in which a first structure 110 is closed with respect to a second structure 120, and FIG. 1B illustrates a state in which the first structure 110 is opened with respect to the second structure 120.

Referring to FIGS. 1A, 1B and 1C, the electronic device 101 may include the first structure 110 (e.g., a first housing) and the second structure 120 (e.g., a second housing) movably disposed in the first structure 110. According to an embodiment of the disclosure, the first structure 110 may be disposed to be reciprocablewith respect to the second structure 120 by a predetermined distance d1 in an illustrated direction as shown in FIG. 1B. According to an embodiment of the disclosure, a main circuit board with electrical components such as an application processor (AP) and a communication processor (CP) mounted thereon may be disposed in the first structure 110. According to an embodiment of the disclosure, a driving module (e.g., a motor), a speaker, a subscriber identity module (SIM) socket, and/or a sub circuit board electrically connected to the main circuit board may be disposed in the second structure 120. According to an embodiment of the disclosure, a rack may be disposed in the second structure 120 and guide sliding movement of the first structure 110 and a display 112. According to an embodiment of the disclosure, the rack may be fixedly disposed on one surface of the second structure 120 and guide a gear connected to the driving module to move in a sliding direction while rotating. According to another embodiment of the disclosure, the rack may be disposed in the first structure 110, and the driving module may be disposed in the second structure 120.According to other embodiments, the various components indicated above may instead be disposed in/on the other structure to that mentioned above, or disposed among the first structure 110 and the second structure 120. According to an embodiment of the disclosure, a first plate 111 of the first structure 110 may include a first surface 111a and a second surface 111b facing in an opposite direction to the first surface 111a. According to an embodiment of the disclosure, the second structure 120 may include a second plate 121, a first sidewall 121a extending to the second plate 121, a second sidewall 121b extending to the first sidewall 121a and the second plate 121,a third sidewall 121c extending to the first sidewall 121a and the second plate 121 and parallel to the second sidewall 121b, and/or a second rear plate 180 (e.g., a rear window). According to an embodiment, the second plate 121, the first sidewall 121a, the second sidewall 121b, and the third sidewall 121c may form a trough (or an enclosure, or an accommodating portion) having one side open to accommodate at least part of the first structure 110 therein. For example, the second structure 120 may be coupled to surround part of the first structure 110, and the first structure 110 may reciprocate with respect to the second structure 120 in a straight line along an arrowed direction①in FIG. 1A. According to an embodiment of the disclosure, the second sidewall 121b and/or the third sidewall 121c may be omitted. According to an embodiment of the disclosure, at least one of the second plate 121, the first sidewall 121a, the second sidewall 121b, or the third sidewall 121c may be formed as an integral structure. According to an embodiment of the disclosure, the second plate 121, the first sidewall 121a, the second sidewall 121b, or the third sidewall 121c may be formed asseparate structures and coupled with each other. According to an embodiment, the second rear plate 180 may cover at least part of the display 112. According to an embodiment of the disclosure, the size of a display screen displayed on the front surface may be changed by raising and lowering the second rear plate 180, e.g., vertically raising and lowering the second rear plate 180. According to an embodiment of the disclosure, as the first structure 110 is movable to the open state and the closed state with respect to the second structure 120 in a first direction (e.g., the arrowed direction①) parallel to the second plate 121 and the second sidewall 121b, the first structure 110, or at least part of the first structure 110,may move tobe at a first distance from the first sidewall 121a in the closed state and at a second distance greater than the first distance from the first sidewall 121a in the open state. According to an embodiment of the disclosure, the electronic device 101 may includeat least one of audio modules 113, 123, and 125, camera modules 115 and 135, an indicator 116 (e.g., a light emitting diode(LED) device), sensor modules114 and 134, key input devices 127, or connector holes 131 and 132. According to an embodiment of the disclosure, the electronic device 101 may include the display 112. According to an embodiment of the disclosure, the display 112 may extend across at least part of the first surface 111a, and include a portion (herafter non-limitingly referred to as a flat portion1 12a)disposed on the first surface 111a, and a portion (hereafter non-limitingly referred to as a bendable portion) extending from the flat portion 112a to a space between the first sidewall 121a and the first structure 110 in the closed state.Note that the flat portion 112a may also be flexible or bendable (although may be coupled to a surface or component which is rigid or not intended to be flexible, such that the flat portion 112a should not bend in normal use of the electronic device), and the bendable portion may also be flat or made flat.For example, the display 112 may be a flexible display with a portion which is flat (corresponding to the flat portion 112a) and a portion which is bent. For example, the bendable portion may be a part of the display 112 which is initially bent and which then, through movement of the first structure 110 away from the second structure 120, is made flat. According to an embodiment of the disclosure, when viewed from above the first plate 111, when the first structure 110 is moved from the closed state to the open state (e.g.,when one of the first structure 110 or the second structure 120 is moved relative to the other one of the first structure 110 or the second structure 120 such that the electronic device 101 extends in the direction of the movement), at least part of the bendable portion of the display may be configured to move toward the flat portion 112a by a predetermined display area EA to form a substantially flat surface between the flat portion 112a and the first sidewall 121a (this may be regarded as an example of changing the size of the display). According to an embodiment, when viewed from above the first plate 111, when the first structure 110 is moved from the closed state to the open state, at least part of the bendable portion of the display may be configured tobe brought into the same orientation as the flat portion 112a (e.g., the at least part of the bendable portion may be moved to be in the same plane as the flat portion 112a) to form a substantially flat surface between the flat portion 112a and the first sidewall 121a (this may be regarded as another example of changing the size of the display).The display 112 may be incorporated with or disposed adjacent to a touch sensing circuit, a pressure sensor that measures the intensity (pressure) of a touch, and/or a digitizer that detects a magnetic field-based stylus pen. For example, the display 112 may include a flexible touchscreen display layer.

According to an embodiment, the audio modules 113, 123, and 125 may include speaker holes 113 and 123, and a microphone hole 125. A microphone for obtaining an external sound may be disposed in the microphone hole 125, and in a certain embodiment, a plurality of microphones may be disposed to detect the direction of a sound. In a certain embodiment, the speaker holes 113 and 123 and the microphone hole 125 may be implemented as a single hole, or a speaker (e.g., a piezo speaker) may be included without the speaker holes 113 and 123. According to an embodiment, a receiver hole 113 may be disposed in the first structure 110, and an external speaker hole 123 or the microphone hole 125 may be disposed in the second structure 120. According to another embodiment, the external speaker hole 123 may be disposed on the second surface 111b of the first plate 111 or a side surface of the first structure 110. According to another embodiment, the microphone hole 125 may be disposed on a side surface of the first structure 110.

According to an embodiment of the disclosure, the sensor modules 114 and 134 may generate an electrical signal or data value corresponding to an internal operation state of the electronic device 101 or an external environmental state. The sensor modules 114 and 134 may include, for example, a first sensor module 114 (e.g., a proximity sensor) disposed on the front surface 111a of the first plate 111, and/or a second sensor module (not shown) (e.g., a fingerprint sensor) and/or a third sensor module 134 (e.g., a heart rate monitor (HRM) sensor) disposed on the second surface 111b of the first plate 111. The electronic device 101 may further include a sensor module (not shown), for example, at least one of a gesture sensor, a gyro sensor, a barometric pressure sensor, a magnetic sensor, an acceleration sensor, a grip sensor, a color sensor, an infrared (IR) sensor, a biometric sensor, a temperature sensor, a humidity sensor, or an illuminance sensor.

According to an embodiment, the camera modules 115 and 135 may include a first camera device 115 disposed on the first surface 111a of the first plate 111 and/or a second camera device 135 disposed on the second surface 111b. The first camera device 115 or the second camera device 135 may include one or more lenses, an image sensor, and/or an image signal processor. According to an embodiment, the second camera device 135 may be disposed on one surface of the second structure 120.

According to an embodiment of the disclosure, the one or more key input devices 127 may be disposed on the second sidewall 121b or the third sidewall 121c of the second structure 120, or may be disposed among the second sidewall 121b and the third sidewall 121c. The electronic device 101 may include a key input device that is not shown, for example, a home key button or a touch pad disposed around the home key button (e.g., a softkey). According to another embodiment, at least some of the key input devices may be located in an area of the first structure 110.

According to an embodiment of the disclosure, the indicator 116 may be disposed on the first surface 11 1a of the first plate 111. The indicator 116 may include, for example, an LED, if the LED is capable of providing state information about the electronic device 101 in the form of light.

According to an embodiment, the connector holes 131 and 132 may include a first connector hole 131that may accommodate a connector (e.g., a universal serial bus (USB) connector) for transmitting and receiving power and/or data to and from an external electronic device, and/or a second connector hole 132 (e.g., an earphone jack) that may accommodate a connector for transmitting and receiving an audio signal to and from an external electronic device. According to an embodiment, the first connector hole 131 or the second connector hole 132 may be disposed on the first sidewall 121a of the second structure 120. According to another embodiment, the first connector hole 131 or the second connector hole 132 may be disposed on a sidewall of the first structure 110.

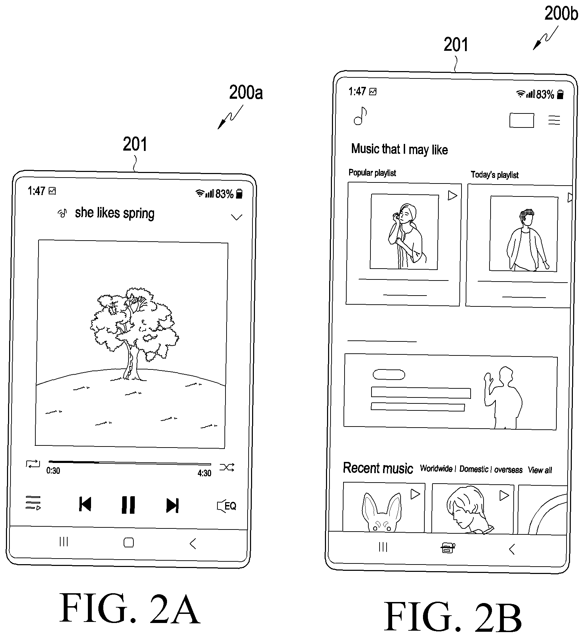

FIGS. 2A to 2C are diagrams 200a to 200c illustrating states of an electronic device based on a state in which a display is inserted into or exposed from a housing in an electronic device according to various embodiments.Note thatuse of the expression "exposed from" should notbe seen to imply that the display, or a part thereof, cannot be viewed when in the housing.For example, at least part of the display may be visible from a front side and/or a rear side of the electronic device (for example, from the rear side of the electronic device, a part of the display may be visible through a window in a rear surface of the electronic device).

Referring to FIG. 2A, an electronic device 201 is shown as being in a first state in which a second housing (e.g., the first structure 110 of FIGS. 1A and 1B) with a display disposed therein is fully inserted into a first housing (e.g., the second structure 120of FIGS. 1A and 1B), and thus the display of the electronic device 201 has a first size (e.g., height).For example, when the second housing is fully inserted into the first housing, the size of a part of the display visible on a front surface of the electronic device 201 may not be further reduced below the first size.

Referring to FIG. 2B, the electronic device 201 is shown as being in a second state in which the second housing (e.g., the first structure 110 of FIGS. 1A and 1B) with the display disposed therein is partially inserted into or partially exposed (or partially extended) from the first housing (e.g., the second structure 120 of FIGS. 1A and 1B), and thus the display of the electronic device 201 has a second size (height) greater than the first size (height).

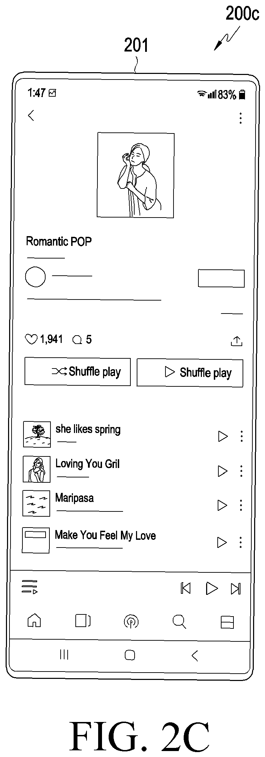

Referring to FIG. 2C, the electronic device 201 is shown as being in a third state in which the second housing (e.g., the first structure 110 of FIGS. 1A and 1B) with the display disposed therein is fully exposed (or fully extended) from the first housing (e.g., the second structure 120 of FIGS. 1A and 1B), and thus the display of the electronic device 201 has a third size (height) greater than the second size (height).For example, when the second housing is fully exposed or fully extended from the first housing, the size of a part of the display visible on a front surface of the electronic device 201 may not be further increased above the first size.

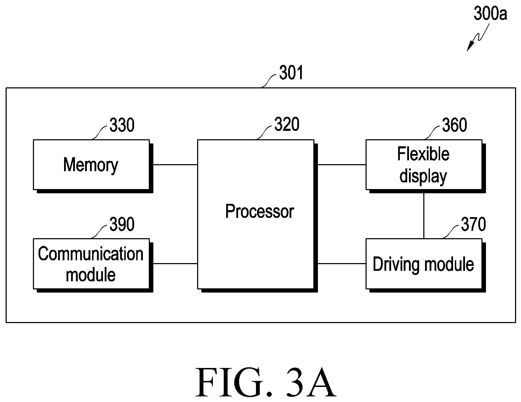

FIG. 3A is a block diagram 300a illustrating an electronic device according to various embodiments.

Referring to FIG. 3A, an electronic device 301 (e.g., the electronic device 101 of FIGS. 1A to 1C and/or the electronic device 201 of FIGS. 2A to 2C) may include a processor 320,memory 330, a flexible display 360, a driving module 370, and/or a communication module 390.

According to various embodiments, when a condition for changing a size of an exposed portion of a flexible display 360 is satisfied, the processor 320 may control an operation of the electronic device associated with changing the size of the exposed portion of the flexible display 360.

According to various embodiments, when a condition for changing a display size is satisfied based on attribute information about a view of an application in displaying the viewon the flexible display 360, the processor 320 may provide at least one control buttonfor changing a display size.

For example, to change a size of the display may include increasing or decreasing the size of a visible area of the display when viewed from a particular direction, such as towards the front surface 111a of electronic device 101 in Fig. 1A. In another example, to change a size of the display may include moving one part of the display into a specific position relative to another part of the display, e.g., moving one part of the display to be substantially planar with another part of the display, thereby providing a larger display surface in the plane.It will be appreciated that a view of an application may be, for example, one or more screens of the application (such as an execution screen), a window of an application (e.g., an execution window), multiple windows corresponding to an application (e.g., in the event that an application provides more than one window at the same time), or data or information otherwise provided by an application for display by the electronic device. The view of the application may include an execution screen of the application. For example, the view of the application may include a first screen initially displayed on the flexible display when the application is executed or a plurality of screens displayed on the flexible display after the first screen. The first screen may include at least one object for displaying the plurality of screens.

A view may be displayed fullscreen in the sense of being provided by the entire display or the entire visible part of the display, or may be displayed on part of the display or part of the visible part of the display. A view may also change in size depending on, for example, activity of the application, a function of the application or the electronic device, or use of the application or the electronic device.

According to an embodiment, the application may provide a view defined with an optimal size, such as an optimal height (e.g., measured in pixels, measured in physical units, measured relative to a part of the electronic device etc.), according to the nature of information displayed on the display (e.g., the optimal height may be associated with information provided by the application), and the attribute information about the view may include information a specified display size (e.g., height) in which the view is to be displayed, when the view is displayed on the display 360. In an example, the information about the specifieddisplaysize in which the view is to be displayed may be preset by a developer of the electronic device and stored in the memory 330. In another example, the information about the specified display sizein which the view is to be displayedmay be preset based on training data of display sizes that a user of the electronic device uses according to view types provided by the application, and stored in the memory 330.In another example, the information about the specified display sizein which the view is to be displayed may be set dynamically, or by the user, or by another means.

According to an embodiment, when a view is displayed according to execution of the application, or a new view is displayed according to view switching of the application, if a specified display size in which the view is to be displayed does not match a current size of the display 360, the processor 320 may determine that the condition is satisfied.

According to an embodiment, when a view of the application is displayed or while the view is being displayed, if a specified display size in which the view is to be displayed does not match the current size of the display 360, the processor 320 may determine that the condition is satisfied.

According to an embodiment, when a view of the application is displayed or while the view is being displayed, if there is a history that the view was previously displayed, and a display size in which the view was previously displayed does not match the current size of the display 360, the processor 320 may determine that the condition is satisfied.

According to an embodiment, upon detection of a user input to a hardware (H/W) key or software (S/W) key for changing the size of the display 360 when aview of the application is displayed or while the view is being displayed, the processor 320 may determine that the condition is satisfied.

According to an embodiment, when a view of the application is displayed or while the view is being displayed, if mismatch between a specified display size in which the view is to be displayed and the current size of the display 360 occursN or more times, the processor 320 may change the current size of the display 360 toinformation about aspecified display size (e.g., height) in which the view is to be displayed, and store the information. For example, in the case where the display size in which the view of the application is to be displayed is predefined as a value A (e.g., a value A pixels in height), when the view of the application is used N or more times with a value B different from the predefined display size, the value A (e.g., such as when a user frequently changes the size of the view of the application to correspond to a display size of value B), the processor 320 may overwrite the display size in which the view of the application is to be displayed with the value B.

According to an embodiment, while being connected to an external electronic device, the processor 320 may additionally store an external condition for changing the size of the display 360 based on an operation state (e.g., exercise state) of the external electronic device or data (e.g., exercise data) received from the external electronic device. The processor 320 may change the size (e.g., height) of the display 360 without an additional user input according to the external condition, while being connected to the external electronic device. According to an embodiment, the processor 320 may set enabling/disabling of the condition for changing a display size (e.g., height) or the external condition according to a user selection. For example, upon detection that the external condition for changing a display size (e.g., height) is disabled, and the external electronic device connected to the electronic device is in an exercise state, the processor 320 may not change the size (e.g., height) of the display in spite of satisfaction of the external condition.

According to an embodiment, when the condition is satisfied, the processor 320 may display at least one control button for changing a display sizein a predetermined area of the display 360.

According to an embodiment, when the condition is satisfied, the processor 320 may display at least one control buttonfor changing a display size in a predetermined area of the display 360, for example, in a fixed area such as a navigation bar area. The processor 320 may display the control button instead of one (e.g., a home button) of a plurality of buttons (e.g., a recent app button, the home button, and a back button) displayed in the navigation bar area. The processor 320 may add the control button to the plurality of buttons (e.g., the recent app button, the home button, and the back button) displayed in the navigation bar area, and display a plurality of buttons (e.g., the recent app button, the home button, the back button, and the control button) at arranged positions in the navigation bar area.

According to an embodiment, when the condition is satisfied, and thus the processor 320 displays the at least one control buttoninthepredetermined area of the display 360, for example, in the fixed area such as the navigation bar area, the processor 320 may display the at least one control button to be visually distinguishable from the plurality of buttons (the recent app button, the home button, and the back button) displayed in the navigation bar area.

According to an embodiment, when the condition is satisfied, and thus the processor 320 displays the at least one control button in thepredetermined area of the display 360, for example, in the fixed area such as the navigation bar area, the processor 320 may display the at least one control buttonin a manner that visually distinguishably indicates that an operation of the control buttonisdifferentaccording to a view of the application. For example, the processor 320 may change the graphical user interface (GUI) of the control button or draw a circle around the control button to indicate thatthe operation of the control buttonis different depending on the view of the application.

According to an embodiment, the processor 320 may change the size of the display in correspondence with attribute (e.g., view size (height)) information about the view based on a user input for selection of the control button.

For example, in the case where the display of the electronic device 301 is in the second state in which the display has the second size (e.g., the second state of FIG. 2B), when the processor 320 identifies a specified display size in which a view is to be displayed as the third size of the display based on attribute information about the view, the processor 320 may switch the display 360 of the electronic device to the third state (e.g., the third state of FIG. 2C) in which the display 360 has the third size by changing the size of the display 360 based on a user input for selection of the control button. The processor 320 may display the view on the display 360 in the third state in which the display 360 of the electronic device has the third size.

For example, when the processor 320 identifies the specified display size in which the view is to be displayed as the first size of the display based on the attribute information about the view in the second state (e.g., the second state of FIG. 2B) in which the display of the electronic device 301 has the second size, the processor 320 may switch the display 360 of the electronic device to the first state (e.g., the first state of FIG. 2A) in which the display 360 has the first size by changing the size of the display 360 based on a user input for selection of the control button. The processor 320 may display the view on the display 360 in the first state in which the display 360 of the electronic device has the first size.

According to an embodiment, upon completion of changing the size of the display in correspondence with the attribute information (e.g., size (height) information) about the view, the processor 320 may release the display of the control button.

According to an embodiment, upon completion of changing the size of the display in correspondence with the attribute information (e.g., size (height) information) about the view, the processor 320 may release the display of the control button in the predetermined area of the display 360.

According to an embodiment, upon completion of changing the size of the display in correspondence with the attribute information (e.g., size (height) information) about the view, the processor 320 may release the display of the control button (e.g., stop displaying the control button) in the predetermined area, for example, the navigation bar area of the display 360.

According to an embodiment, when the processor 320 detects a user input in an area other than the predetermined area in which at least one control button for changing a display size is displayed or fails to identify a user input to the control button for a predetermined time during display of the at least one control button in view of satisfaction of the condition, the processor 320 may release the display of the control button.

According to various embodiments, upon detection of a first gesture in a predetermined area of the flexible display 360 during display of a view of an application on the flexible display 360, the processor 320 may provide at least one control button for changing a display size. In an embodiment, detection of the first gesture corresponds to the condition for changing a size of the display being satisfied, where the attribute information relates to the detection operation or first gesture.

According to an embodiment, upon detection of a first gesture (left swipe) in a predetermined area of the flexible display 360 during display of a view of an application on the flexible display 360, the processor 320 may display at least one control buttonfor changing a display size in the predetermined area.

According to an embodiment, upon detection of a first gesture (e.g., left swipe) on one (e.g., the home button) of a plurality of buttons (e.g., the recent app button, the home button, and the back button) displayed in a predetermined area of the flexible display 360, for example, in a fixed area such as the navigation bar area during display of a view of an application on the flexible display 360, the processor 320 may displaythecontrol buttoninstead of the one (e.g., the home button) of the plurality of buttons (e.g., the recent app button, the home button, and the back button). The processor 320 may add the control button to the plurality of buttons (e.g., the recent app button, the home button, and the back button) displayed in the navigation bar area, and display a plurality of buttons (e.g., the recent app button, the home button, the back button, and the control button) at arranged positions in the navigation bar area.

According to an embodiment, the processor 320 may display at least onecontrolbuttonfor changing a display size based on detection of a first gesture of the user, regardless of whether the condition for changing a display sizeis satisfied based on the attribute information abouttheview. That is, according an embodiment, the detection of the first gesture does not correspond to the condition being satisfied, but instead separately results in the at least one control button being displayed.

According to an embodiment, the processor 320 may display the at least one control buttonfor changing a display size based on the first gesture, and upon completion of changing the size of the display based on a user input to the control button, release the display of the control buttonon the display 360.

According to an embodiment, when the processor 320 changes the size of the display 360 based on a user input to the at least one control buttonfor changing a display size, displayed according to detection of the first gesture, the processor 320 may store information about the view and a display size that the user has selected to display the view as user training data for specified display size (e.g., height) information for displaying the view.

According to various embodiments, when the condition for changing a display size is satisfied based on attribute information about a view of an application in displaying the view of the application on the flexible display 360, the processor 320 may provide a visual effect that a predetermined area of the display rolls away to disappear and a control areaincludingat least one control buttonfor changing a display size is displayed.

According to an embodiment, upon identification that the condition is satisfied during display of a plurality of buttons (e.g., the recent app button, the home button, and the back button) in a predetermined area of the display 360, for example, in a fixed area such as a navigation bar area, the processor 320 may provide a visual effect that the navigation bar area rolls away to disappear and acontrol area newly appears while the navigation bar area is disappearing. In this case, the processor 320 may provide the navigation bar area in two dimensions (2D) or threedimensions (3D). According to an embodiment, at least one button included in the control area may include at least one of,for example, a button for stopping change of a display size, a button for changing a display size in correspondence witha specified display size in which a view is to be displayed, or a button for changing to a maximum display size or a minimum display size.

According to an embodiment, upon completion of changing a display size based on a user input to at least one button included in the control area, the processor 320 may provide a visual effect that the control area rolls away to disappear and the navigation bar area appears while the control area is disappearing.

According to various embodiments, when the condition for changing a display size is satisfied based on attribute information about a view of an application in displaying the view on the flexible display 360, the processor 320 may display a visual indicator at a boundary of a predetermined area of the display, and provide a control area including at least one control button for changing a display size based on a user input to the visual indicator.

According to an embodiment, upon identification that the condition is satisfied while displaying a plurality of buttons (e.g., the recent app button, the home button, and the back button) in a predetermined area of the display 360, for example, in a fixed area such as a navigation bar area, the processor 320 may display a visual indicator at a boundary of the navigation bar area, and provide a control area including at least one control button for changing a display size based on a user input to the visual indicator.The processor 320 may expand the navigation bar area and display the control area in a partial area of the expanded navigation bar area. The processor 320 may further display the control area at a position adjacent to the navigation bar area.

According to an embodiment, at least one button included in the control area may include at least one of, for example, a button for stopping change of a display size, a button for changing a display size in correspondence with a specified display size in which a view is to be displayed, or a button for changing to a maximum display size or a minimum display size.

According to an embodiment, upon completion of changing the size of the display, the processor 320 may release the display of the control area on the display 360 based on a user input to at least one button included in the control area. The processor 320 may release the display of the control area by reducing the expanded navigation bar area to a previous size. The processor 320 may release the display of the control area added to theposition adjacent to the navigation bar area.

According to various embodiments, when the condition for changing a display size is satisfied based on attribute information about a view of an application in displaying the view on the flexible display 360, the processor 320 may display an indicator in a predetermined area of the display and provide a control barfor changing a display size based on a user input to the indicator.

According to an embodiment, upon identification that the condition is satisfied whiledisplayinga plurality of buttons (e.g., the recent app button, the home button, and the back button) in a predetermined area of the display 360, for example, in a fixed area such as a navigation bar area, the processor 320 may additionally display an indicator related to changing of a display size in the navigation bar area. The processor 320 may display a control bar on the display 360 based on a user input to the indicator. The processor 320 may display the control bar in a partial area that does not overlap with the navigation bar area on the display 360. The processor 320 may display the control bar by changing the position of the control barin correspondence with a user movement input.

According to an embodiment, when displaying the control bar, the processor 320 may release the display of the indicator in the navigation bar area.

According to an embodiment, when the processor 320 fails to detect a user input to the control area for a predetermined time while displaying the control bar in a first size based on selection of the indicator, the processor 320 may release the display of the control area and additionally display the indicator in the navigation bar area.

According to an embodiment, upon detection of a second gesture (e.g., upward swipe) on the control barwhile displaying the control bar in the first size based on the selection of the indicator, the processor 320 may enlargeand display the control bar in a second size larger than the first size.

According to an embodiment, when the processor 320 fails to detect a user input to the control area for a predetermined time while displaying the control barin the second size based on selection of the indicator, the processor 320 may release the display of the control bar and additionally display the indicator in the navigation bar area.

According to an embodiment, the processor 320 may change (or adjust) the size of the display in correspondence with a user input for movingan up pointer or a down pointer included in the control bardisplayed as enlarged to the second size.

According to an embodiment, upon completion of changing (or adjusting) the size of the display using the control bar, the processor 320 may release the display of the control bar. According to various embodiments, when the condition for changing a display size is satisfied based on attribute information about a view of an application in displaying the view on the flexible display 360, the processor 320 may display an indicator in a predetermined area of the display, and provide a control area including a control barforchanging a display size and a cancel button for canceling a display size change based on a user input to the indicator.

According to an embodiment, upon identification that the condition is satisfied while displayinga plurality of buttons (e.g., the recent app button, the home button, and the back button) in a predetermined area of the display 360, for example, in a fixed area such as a navigation bar area, the processor 320 may display an indicator related to changing of a display size in the navigation bar area.

According to an embodiment, when the processor 320 fails to detect a user input to the indicator for a predetermined time while displaying the indicator related to changing of a display size in the navigation bar area, the processor 320 may release the display of the indicator in the navigation bar area.

According to an embodiment, the processor 320 may display a control area including a control bar and a cancel button for canceling a display size change on the display 360 based on a user input to the indicator. The processor 320 may display the control area in an area that does not overlap with the navigation bar area on the display 360. The processor 320 may display the control area including the control bar by changing the position of the control area in correspondence with a user movement input.

According to an embodiment, the processor 320 may change (or adjust) the size of the display in correspondence with a user up/down movement input detected in the control bar included in the control area. Upon completion of changing the size of the display using the control bar, the processor 320 may release the display of the control area.

According to an embodiment, the processor 320 may cancel a display size change function by switching to a state before the indicator is displayed in the navigation bar, based on a user input to the cancel button included in the control area.

According to various embodiments, upon detection of reception of data from an external electronic device (e.g., a wearable electronic device) connected to the electronic device 301 for communication, the processor 320 may provide at least one control button for changing a display size based on user history information for the data.

According to an embodiment, upon receipt of data from the external electronic device (e.g., the wearable electronic device), if previous display size information used to display the data is stored as the user history information, the processor 320 may compare the display size information based on the user history information with information about a current size of the display 360. When the information does not match as a result of the comparison, the processor 320 may identify that the condition for changing a display size is satisfied, and provide at least one control button for changing a display size on the display.

According to an embodiment, when the condition is satisfied, the processor 320 may display at least one control button for changing a display size in a predetermined area of the display 360, for example, in a fixed area such as the navigation bar area. The processor 320 may display the control button instead of one (e.g., the home button) of a plurality of buttons (the recent app button, the home button, and the back button) displayed in the navigation bar area. The processor 320 may add the control button to the plurality of buttons (the recent app button, the home button, and the back button) displayed in the navigation bar area, and display a plurality of buttons (the recent app button, the home button, the back button, and the control button) at arranged positions in the navigation bar area.

According to an embodiment, upon completion of changing (or adjusting) the size of the display based on a user input to the control button, the processor 320 may release the display of the control button in the navigation bar area.

According to various embodiments, the processor 320 may be configured to:when a condition for changing a size of the display is satisfied, automatically change the size of the display (e.g., automatically change a size of a visible or exposed portion of the display) based on the condition or on the attribute information, instead of or in addition to providing at least one control button for changing the size of the display. For example, the processor may change the size of the display to correspond to a specified display size associated with the view of the application. In some examples, this may result from a view of the application changing such that the view requires, or prefers, more space on the display, and so prompting the processor to control to increase the size of the visible portion of the display. In another example, upon detecting a user gesture to increase or reduce the size of the display, the processor may increase or reduce the size of the display without displaying the at least one control button or in addition to displaying the at least one control button. For instance, the size of the display could be automatically extended towards a maximum visible size (or contracted/reduced towards a minimum visible size) until interrupted by a user command or further extension (or contraction) is not possible.

According to various embodiments, the memory 330 may store attribute information abouteach of a plurality of views (e.g., information about a specified display size in which the view is to be displayed) provided by each application, for each application type.

According to various embodiments, the display 360 may be fully inserted into the housing (e.g., the second structure 120 of FIGS. 1A to 1C) (e.g., the first state of FIG. 2A), partially inserted into or partially exposed, or partially extended, from the housing (e.g., the second state of FIG. 2B), or fully exposed or fully extendedfrom the housing (e.g., the third state of FIG. 2C).

According to various embodiments, the driving module 370 may include a driver to expose the display 360 to the outside of the housing (e.g., the second structure 120 of FIGS. 1A to 1C) of the electronic device or to insert the display 360 into the housing.

According to various embodiments, the communication module 390 may include a plurality of communication circuits, andinclude at least one of a wireless local area network (WLAN) module (not shown) or a short-range communication module (not shown), and the short-distance communication module (not shown) may include an ultra wideband(UWB) communication module, a wireless fidelity (Wi-Fi) communication module, a near field communication(NFC) communication module, a Bluetooth legacy communication module, and/or a Bluetooth low energy (BLE) communication module.

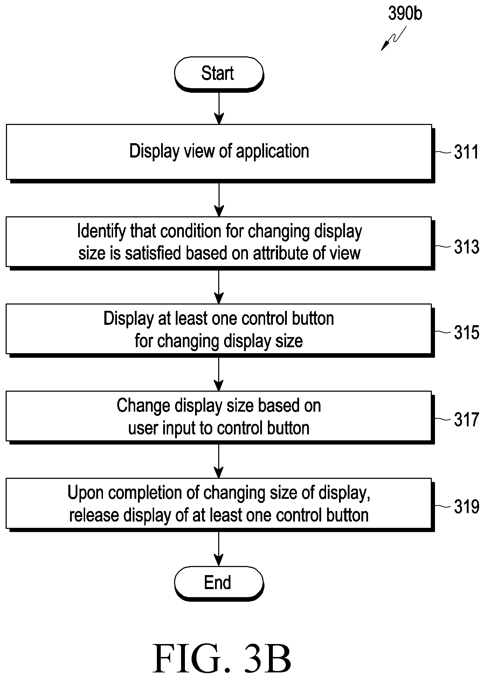

FIG. 3B is a flowchart 300b illustrating an operation of adjusting the size of a display in an electronic device according to various embodiments. The operation of adjusting the size of the display may include operations 311 to 319. According to an embodiment, at least one of operations 311 to 319 may be omitted, the order of some operations may be changed, or another operation may be added.

In operation 311, the electronic device (e.g., the electronic device 101 of FIGS. 1A to 1C, the electronic device 201 of FIGS. 2A to 2C, and the electronic device 301 of FIG. 3A) may display a view (screen) of an application.

According to an embodiment, the application may provide a plurality of views according to the amount of information displayed on the display (e.g., the display 360 of FIG. 3A), and attribute information about a view may include information about a specified display size (e.g., a height) in which the view is to be displayed, when the view is displayed on the display. The information about the specified display size (e.g., height) in which the view is to be displayed may be preset by a developer of the electronic device and stored in memory (e.g., the memory 330 of FIG. 3A). The information about the specified display size (height) in which the view is to be displayed may be preset and stored in the memory based on training data of display sizes that a user of the electronic device uses according to view types provided by the application.

In operation 313, the electronic device (e.g., the electronic device 101 of FIGS. 1A to 1C, the electronic device 201 of FIGS. 2A to 2C, or the electronic device 301 of FIG. 3A) may identify whether a condition for changing the size of the display (e.g., the display 360 of FIG. 3A) is satisfied based on an attribute of the view.

According to an embodiment, before the view is displayed according to execution of the application, when the view is displayed, or when a new view is displayed according to view switching of the application, if aspecifieddisplay size in which the view is to be displayed does not match a current size of the display 360, the electronic device may identify that the condition is satisfied.

According to an embodiment, upon receipt of a command (or request) for displaying the view according to execution of the application, if the specified display size in which the view is to be displayed does not match the current size of the display 360, the electronic device may identify that the condition is satisfied.

According to an embodiment, when the view is displayed or while the view is being displayed, if the specified display size in which the view is to be displayed does not match the current size of the display 360, the electronic device may identify that the condition is satisfied.

According to an embodiment, when the view of the application is displayed or while the view is being displayed, if there is a history that the view was previously displayed, and a display size in which the view was previously displayed does not match the current size of the display 360, the electronic device may determine that the condition is satisfied.

According to an embodiment, upon detection of a user input to an H/W key or S/W key for changing the size of the display 360 when the view of the application is displayed or while the view is being displayed, the electronic device may determine that the condition is satisfied.

It will be appreciated that the condition may be defined in other ways; that is, the above examples of situations in which the condition is determined to be satisfied are nonlimiting.

According to an embodiment, the processor 320 may set the specified display size in which the view of the application is to be displayed to a display size that the user selects on a setting screen or a display size that the user uses frequently (e.g., a predetermined number of or more times) according to the type of the application or the view of the application.

In operation 315, the electronic device (e.g., the electronic device 101 of FIGS. 1A to 1C, the electronic device 201 of FIGS. 2A to 2C, and the electronic device 301 of FIG. 3A) may display at least one control button for changing the size of the display (e.g., the display 360 of FIG. 3A).Alternatively or additionally, the electronic device may automatically change display size (e.g., size of the visible part of the display) based on determining the condition to be satisfied; e.g., the electronic device may automatically adjust the display side to the specified display size and, optionally, display at least one control button for changing the size of the display (e.g., in case a user may wish to further modify the display size from the specified display size). It will be appreciated that, in some embodiments where the display size is automatically changed, the method may end without display of the at least one control button once the display size is changed according to the specified display size.

According to an embodiment, when the condition for changing a display size is satisfied based on the attribute of the view of the application, the electronic device may display at least one control button for changing a display size, whereas when the condition is not satisfied, the electronic device may not display the at least one control button.

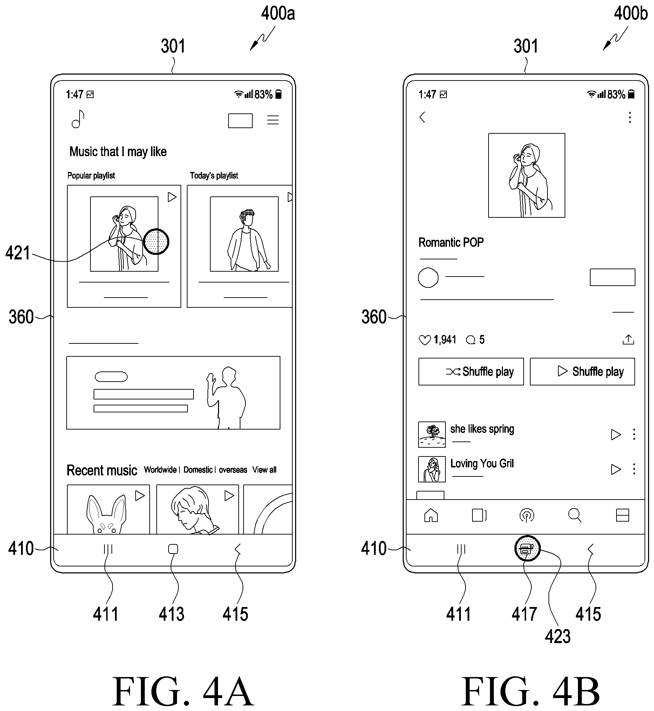

According to an embodiment, the electronic device may display the at least one control button for changing a display size in a predetermined area of the display 360, for example, in a fixed area such as a navigation bar area. The electronic device may display the control button (e.g., a control button 417 of FIG. 4B) instead of one (e.g., a home button) of a plurality of buttons (e.g., a recent app button, the home button, and a back button) displayed in the navigation bar area.

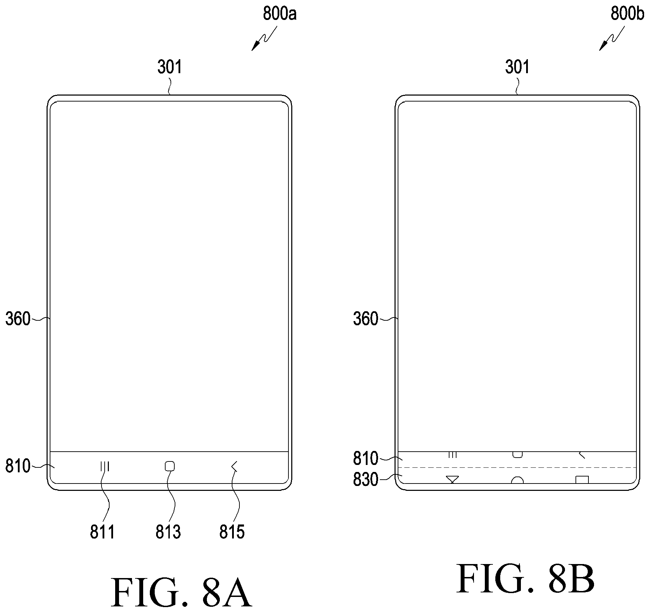

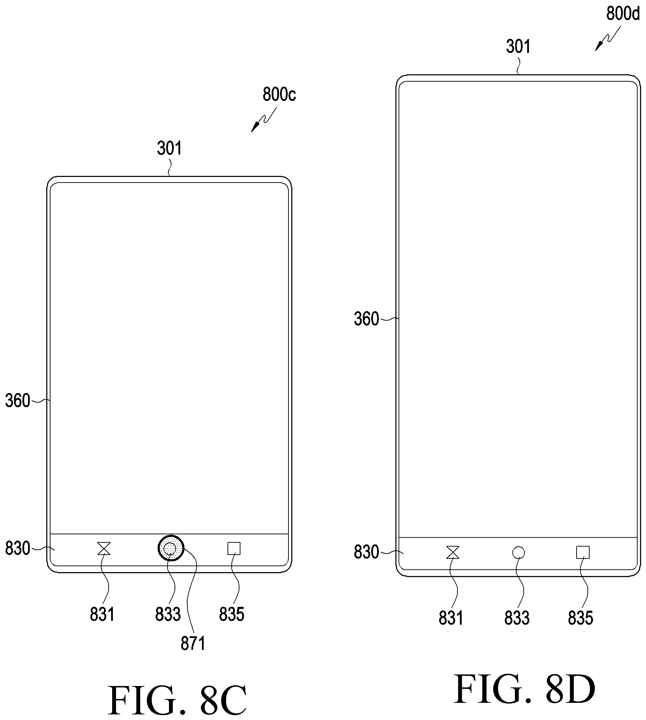

According to an embodiment, the electronic device may provide a visual effect that a predetermined area of the display including the plurality of buttons (e.g., the recent app button, the home button, and the back button), for example, the navigation bar area (e.g., a navigation area 810 of FIG. 8A) rolls away to disappear, and a control area (e.g., a control area 830 of FIG. 8C) including at least one control button newly appears while the navigation bar area is disappearing

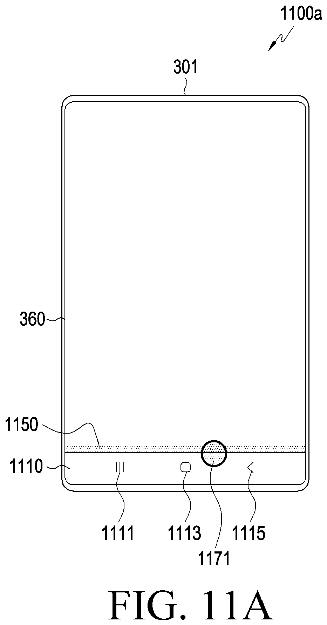

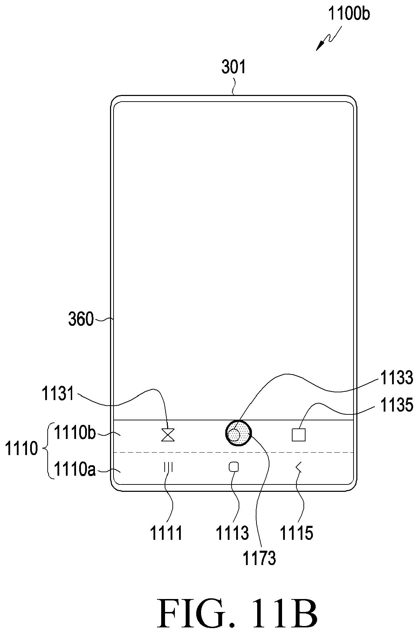

According to an embodiment, the electronic device may display a visual indicator at a boundary of a predetermined area of the display including a plurality of buttons (e.g., the recent app button, the home button, and the back button), for example, a navigation bar area (e.g., a navigation area 1110 of FIG. 11A), and display acontrol area including at least one control button for displaying a display size based on a user input to the visual indicator. The electronic device may expand the navigation bar area (e.g., 1110 of FIG. 11B) and display the control area in a partial area (e.g., a second area 1110b of FIG. 11B) of the expanded navigation bar area.

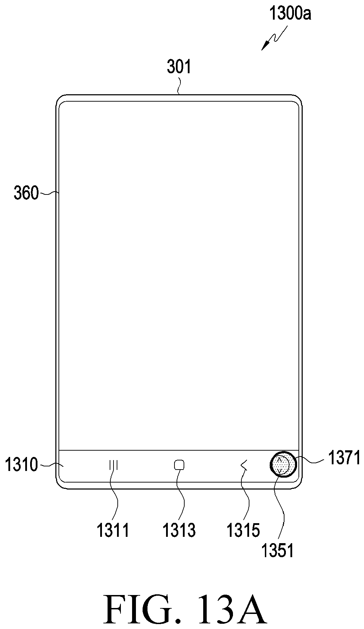

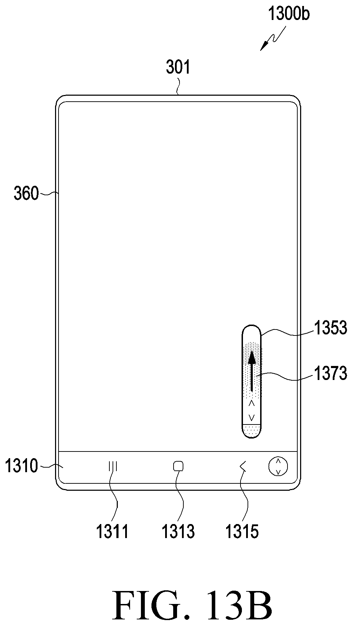

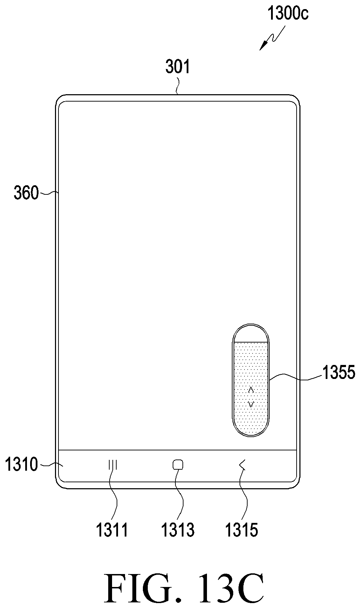

According to an embodiment, the electronic device may additionally display an indicator (e.g., an indicator 1351 of FIG. 13A) related to changing of a display size ina predetermined area of the display including a plurality of buttons (e.g., the recent app button, the home button, and the back button), for example, a navigation bar area (e.g., a navigation area 1310 of FIG. 13A). The electronic device may display acontrol bar in a partial area that does not overlap with the navigation bar area on the display based on a user input to the indicator. Upon detection of a second gesture (e.g., upward swipe) in the control bar while displaying the control bar (e.g., a control bar 1353 of FIG. 13B) in a first size based on selection of the indicator, the electronic device may display the control bar (e.g., a control bar 1355 of FIG. 13C) as enlarged to a second size larger than the first size.

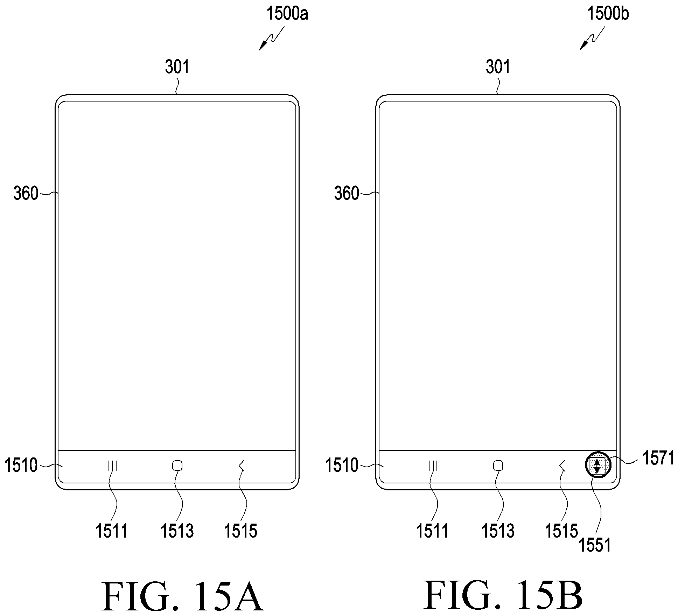

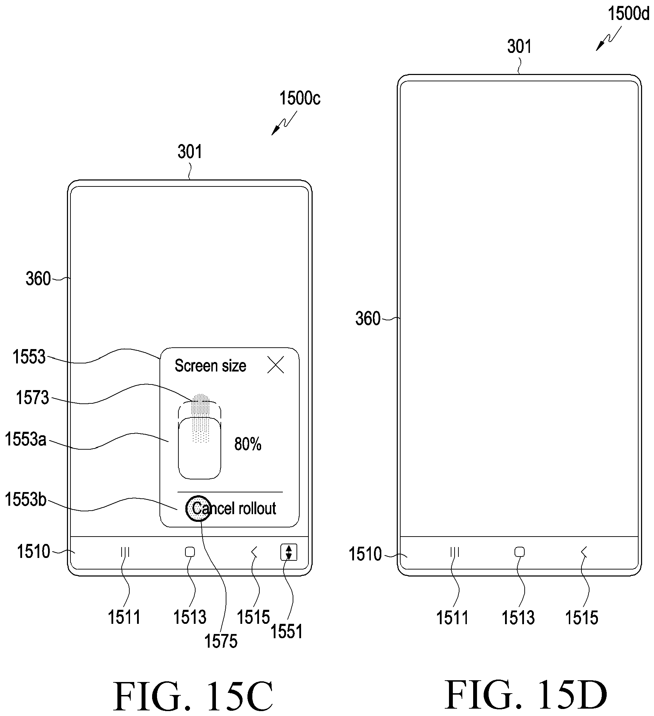

According to an embodiment, the electronic device may display an indicator (e.g., an indicator 1551 of FIG. 15B) related to changing of a display size in a predetermined area of the display including a plurality of buttons (e.g., the recent app button, the home button, and the back button), for example, a navigation bar area (e.g., a navigation area 1510) of FIG. 15B). The electronic device may display a control area (e.g., a control area 1553 of FIG. 15C) including a control bar and a cancel button for cancelling a display size change on the display based on a user input to the indicator..

In operation 317, the electronic device (e.g., the electronic device 101 of FIGS. 1A to 1C, the electronic device 201 of FIGS. 2A to 2C, and the electronic device 301 of FIG. 3A) may change the size of the display based on a user input to the control button.It will be appreciated that this operation may be omitted if the electronic device automatically adjusts the size of the display.

According to an embodiment, the electronic device may change the size of the display to the specified display size in which the view is to be displayed based on a user input to acontrol button (e.g., thecontrol button 417 of FIG. 4B) in a navigation bar area.Optionally,this may take place while displaying the recent app button, the control button, and the back button in a predetermined area of the display, for example, in the navigation bar area (e.g., the navigation area 410 of FIG. 4B).

According to an embodiment, the electronic device may change the size of the display to the specified display size in which the view is to be displayed based on a user input to one of at least one control button included in acontrol area (e.g., 830 of FIG 8C) displayed instead of the navigation bar area at a position of the predetermined area of the display, for example, the navigation bar area.

According to an embodiment, the electronic device may change the size of the display to the specified size in which the view is to be displayed, based on a user input to one of at least one control button included in the control area, while expanding the predetermined area of the display, for example, the navigation bar area and displaying the control area in a partial area (e.g., the second area 1110b of FIG. 11B) of the expanded navigation bar area.

According to an embodiment, the electronic device may change (or adjust) the size of the display in correspondence with a user input for moving an up/down pointer included in a control bar, while displaying thecontrol bar (e.g., theexpandedcontrol bar1355) of FIG. 13C) in a partial area that does not overlap with a predetermined area of the display, for example, the navigation bar area.

According to an embodiment, the electronic device may change (or adjust) the size of the display in correspondence with a user up/down movement input detected in acontrol bar (e.g., a control bar 1553a of FIG. 15C) included in a control area (e.g., thecontrol area 1553 of FIG. 15C) including thecontrol bar and a cancel button for canceling a display size change, while displaying the control area in a partial area that does not overlap with a predetermined area of the display, for example, a navigation bar area.

In operation 319, upon completion of changing the size of the display.The electronic device (e.g., the electronic device 101 of FIGS. 1A to 1C, the electronic device 201 of FIGS. 2A to 2C, and the electronic device 301 of FIG. 3A) may release the display of the at least one control button.It will be appreciated that this operation may be omitted if the electronic device automatically adjusts the size of the display.

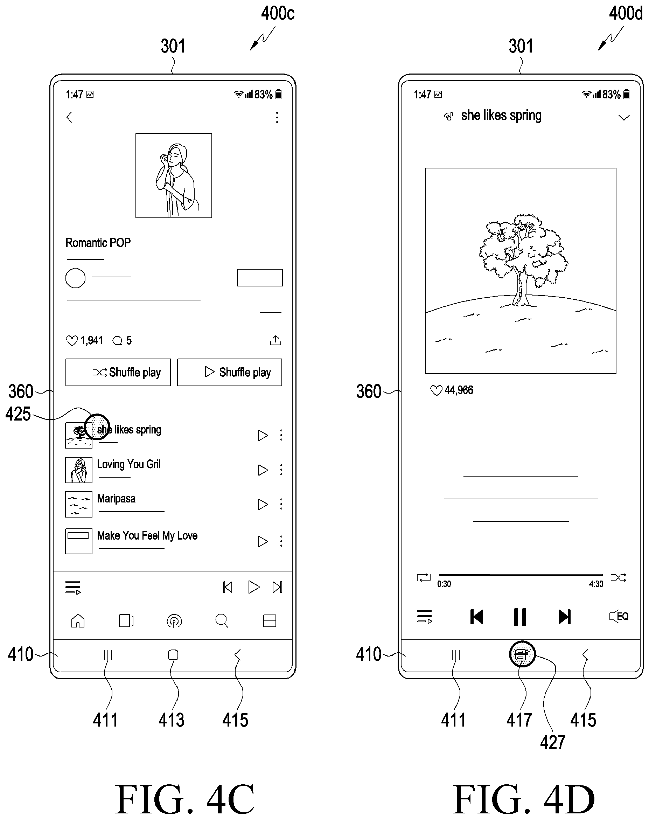

According to an embodiment, the electronic device may release the display of the control button among the recent app button, the control button, and the back button included in the predetermined area of the display, for example, in the navigation bar area (e.g., the navigation area 410 of FIG. 4B), and display the recent app button, the home button, and the back button in the navigation bar area (e.g., the navigation area 410 of FIG. 4C).

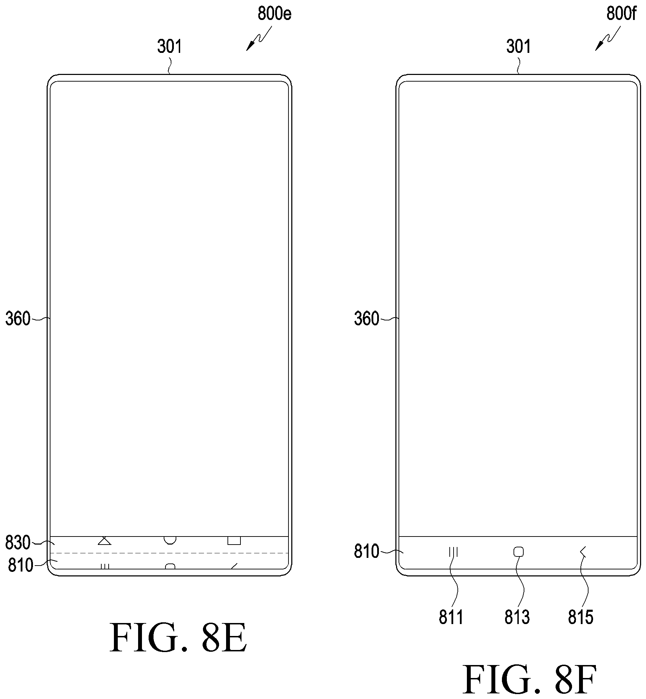

According to an embodiment, the electronic device may provide a visual effect that the control area (e.g., 830 of FIG. 8C) displayed at a position of the predetermined area of the display, for example, the navigation bar area, instead of the navigation bar area rolls away to disappear, and the navigation bar area (e.g., the navigation bar area 810 of FIG. 8F) appears while the control area is disappearing.

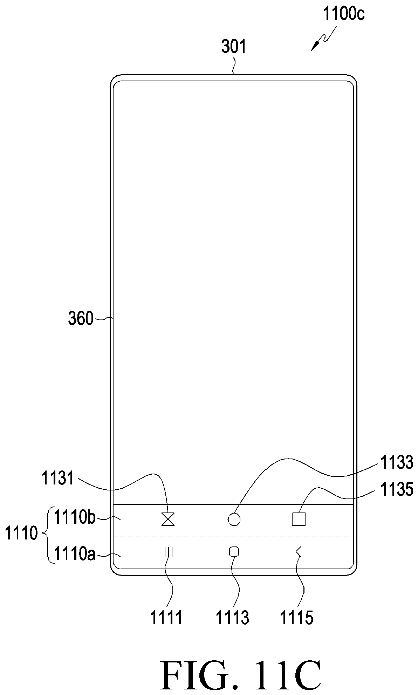

According to an embodiment, the electronic device may release the display of the control area by reducingthe predetermined area of the display, for example, the expanded navigation area (e.g., the navigation area 1110 of FIG. 11C) including thecontrol area to a previous size.

According to an embodiment, the electronic device may release the display of the control bar (e.g., the expandedcontrol bar 1355) of FIG. 13C) displayed in the partial area that does not overlap with the predetermined area of the display, for example, the navigation area.

According to an embodiment, the electronic device may release the display of the control area (e.g., the control area 1553 of FIG. 15C) including the control barand the cancel button for cancelling a display size change, in the partial area that does not overlap with the predetermined area of the display, for example, the navigation area.

FIGS. 4A to 4E are diagrams 400a to 400e illustrating an operation of adjusting the size of a display in an electronic device according to various embodiments.

Referring to FIG. 4A, in the second state (e.g., the second state of FIG. 2B) in which the display 360 is partially inserted into or partially exposed (or partially extended)from the second housing (e.g., the first structure 120 of FIGS. 1A and 1B) and thus has the second size, the electronic device 301 may display a first view of a music application on the display 360 according to execution of the music application, and display a plurality of buttons including a recent app button 411, a home button 413, and a back button 415 in a navigation bar area 410 of the display. Upon detection of a user selection 421 of a first item representing an album of a specific singer in the first view, the electronic device 301 may display a second view of the music application, in which a list of songs of the specific singer may be displayed, as illustrated in FIG. 4B.

Referring to FIG. 4B, when or while displaying the second view on the display 360, the electronic device 301 may identify whether the condition for changing a display size is satisfied based on attribute information about the second view. Upon identification of a specified display size in which the second view is to be displayed as the third size of the display based on the attribute information about the second view, the electronic device 301 may identify that the condition for changing a display size is satisfied because the specified third size of the display in which the second view is to be displayed does not match the second that is the current size of the display. The electronic device 301 may display a plurality of buttons including the recent app button 411, thecontrol button 417, and the back button 415 in the navigation bar area 410 by releasing the display of the home button 413 and displaying thecontrol button 417 in the navigation bar area 410 based on the satisfaction of the condition. The electronic device 301 may switch the display to the third state (e.g., the third state of FIG. 2C) in which the display has the third size by changing the size of the display 360 based on a user input 423 to the control button 417, as illustrated in FIG. 4C.

Referring to FIG. 4C, when the electronic device 301 identifies that the size of the display 360 has been changed to the third size that is the specified display size in which the second view is to be displayed, the electronic device 301 may display the plurality of buttons including the recent app button 411, the home button 413, and the back button 415 in the navigation bar area 410 by releasing the display of the control button 416 and displaying the home button 413 in the navigation bar area 410. Upon identification of a user input 425 for playback of a specific song in the song list of the specific singer included in the second view, the electronic device 301 may display a third view of the music application in which playback of the specific song may be displayed on the display 360, as illustrated in FIG. 4D.

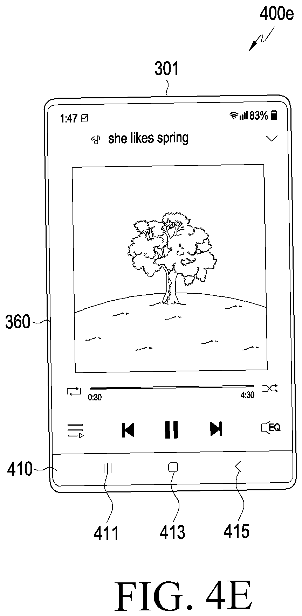

Referring to FIG. 4D, when or while displaying the third view on the display 360, the electronic device 301 may identify whether the condition for changing a display size is satisfied based on attribute information about the third view. Upon identification of a specified display size in which the third view is to be displayed as the first size of the display based on the attribute information about the third view, the electronic device 301 may identify that the condition for changing a display size is satisfied because the specified first size of the display in which the third view is to be displayed does not match the third size that is the current size of the display. The electronic device 301 may display the plurality of buttons including the recent app button 411, the control button 417, and the back button 415 in the navigation bar area 410 by releasing the display of the home button 413 and displaying the control button 417 in the navigation bar area 410 based on the satisfaction of the condition. The electronic device 301 may switch the display to the first state (e.g., the first state of FIG. 2A) in which the display has the first size by changing the size of the display 360 based on a user input 427 to the control button 417, as illustrated in FIG. 4E.

Referring to FIG. 4E, when the electronic device 301 identifies that the size of the display 360 has been changed to the first size that is the specified display size in which the third view is to be displayed, the electronic device 301 may display the plurality of buttons including the recent app button 411, the home button 413, and the back button 415 in the navigation bar area 410 by releasing the display of the control button 416 and displaying the home button 413 in the navigation bar area 410.

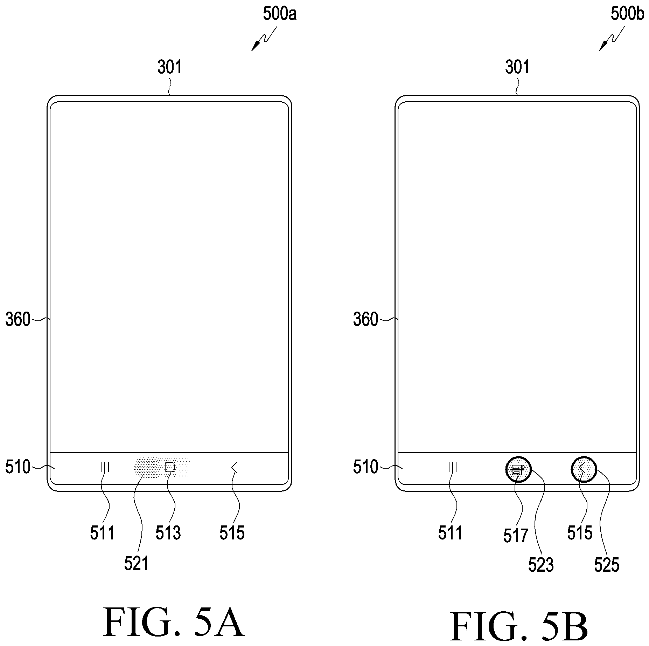

FIGS. 5A to 5C are diagrams 500a to 500c illustrating an operation of adjusting the size of a display in an electronic device according to various embodiments.

Referring to FIG. 5A, when the display 360 is in the second state (e.g., the second state of FIG. 2B) in which the display 360 is partially inserted into or partially exposed from the housing (e.g., the first structure 120 of FIGS. 1A and 1B) and thus has the second size, and a navigation bar area 510 is set to button display, the electronic device 301 may display a plurality of buttons including a recent app button 511, a home button 513, and a back button 515 in a navigation bar area 510 of the display 360. Upon detection of a first gesture (e.g., left swipe) 521 on the home button 513 among the plurality of buttons displayed in the navigation bar area 510, the electronic device 301 may display a plurality of buttons including the recent app button 511, a control button 517, and the back button 515 in the navigation bar area 510 by releasing the display of the home button 513 and displaying the control button 517 in the navigation bar area 510, as illustrated in FIG. 5B.

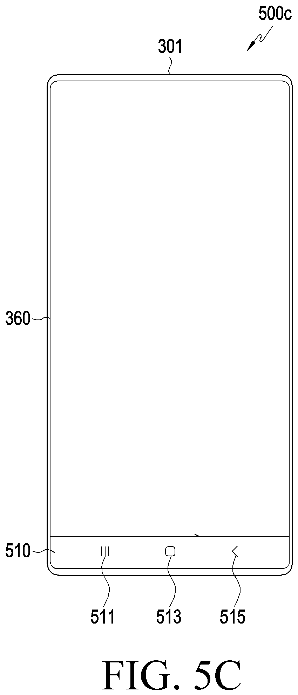

Referring to FIG. 5B, the electronic device 301 may switch the display to the third state (e.g., the third state of FIG. 2C) in which the display has the third size by changing the size of the display 360 as illustrated in FIG. 5C, based on a user input 523 to the control button 517 in the navigation bar area 510. The electronic device 301 may change the size of the display according to the type of a user input to the control button 517. For example, upon identification of occurrence of a single touch corresponding to a user input on the control button 517, the electronic device 301 may switch the display to the first state (e.g., the first state of FIG. 2A) in which the display has the first size by changing the size of the display 360. Upon identification of occurrence of a double touch corresponding to a user input on the control button 517, the electronic device 301 may switch the display to the third state (e.g., the third state of FIG. 2C) in which the display has the third size by changing the size of the display 360.

Upon identification that the size of the display 360 has been changed to the third size, the electronic device 301 may release the display of the control button 517 in the navigation bar area 510, as illustrated in FIG. 5C.

The electronic device 301 may display the plurality of buttons including the recent app button 511, the home button 513, and the back button 515 in the navigation bar area 510 by releasing the display of the control button 517 and displaying the home button 513 in the navigation bar area 510 as illustrated in FIG. 5C.

In FIG. 5B, upon identification of a user input 525 to the back button 515 while displaying the plurality of buttons including the recent app button 511, the control button 517, and the back button 515, the electronic device 301 may display the plurality of buttons including the recent app button 511, the home button 513, and the back button 515 in the navigation bar area 510 by releasing the display of the control button 517 and displaying the home button 513 in the navigation bar area 510 as illustrated in FIG. 5A.

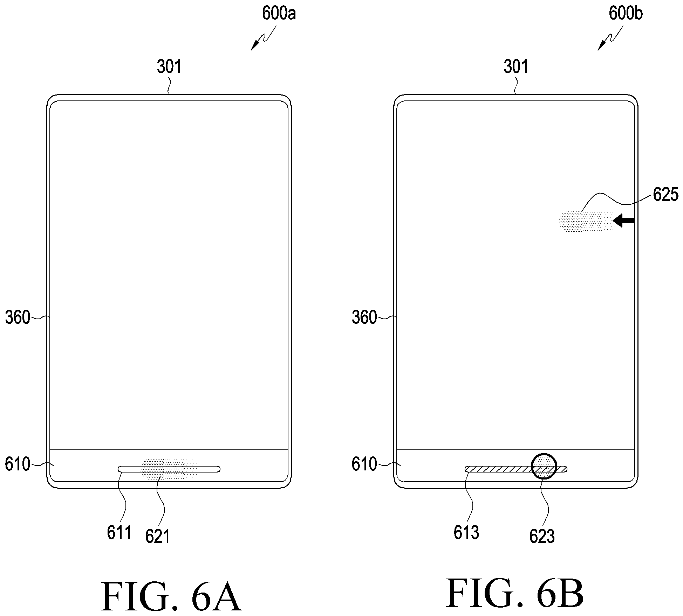

FIGS. 6A to 6C are diagrams 600a to 600c illustrating an operation of adjusting the size of a display in an electronic device according to various embodiments.

Referring to FIG. 6A, when the display 360 is in the second state (e.g., the second state of FIG. 2B) in which the display 360 is partially inserted into or partially exposed from the housing (e.g., the first structure 120 of FIGS. 1A and 1B) and thus has the second size, and a navigation bar area 610 is set to swipe gesture display, the electronic device 301 may display a first indicator 611 indicating the swipe gesture setting in the navigation bar area 610 of the display 360. Upon detection of a first gesture (e.g., left swipe) 621 for changing a display size on the first indicator 611 displayed in the navigation bar area 610, the electronic device 301 may display a second indicator 613 for changing a display size in the navigation bar area 610, as illustrated in FIG. 6B.

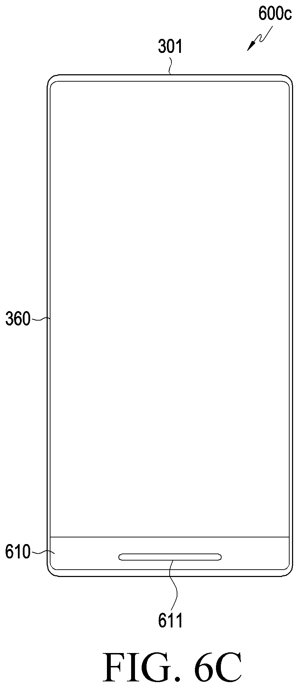

Referring to FIG. 6B, upon identification of a user input 623 to the second indicator 613 displayed in the navigation bar area 610, the electronic device 301 may switch the display to the third state (e.g., the third state of FIG. 2C) in which the display has the third size by changing the size of the display 360 as illustrated in FIG. 6C. The electronic device 301 may change the size of the display according to the type of a user input to the second indicator 613. For example, upon identification of occurrence of a single touch corresponding to a user input onthe second indicator 613, the electronic device 301 may switch the display to the first state (e.g., the first state of FIG. 2A) in which the display has the first size by changing the size of the display 360. Upon identification of occurrence of a double touch corresponding to a user input onthe second indicator 613, the electronic device 301 may switch the display to the third state (e.g., the third state of FIG. 2C) in which the display has the third size by changing the size of the display 360.

Upon identification that the size of the display 360 has been changed to the third size, the electronic device 301 may release the display of the second indicator 613 in the navigation bar area 510, as illustrated in FIG. 6C.

As illustrated in FIG. 6C, the electronic device 301 may release the display of the second indicator 613 and display the first indicator 611 in the navigation bar area 610.

In FIG. 6B, upon identification of a first gesture (e.g., left swipe 625) in a partial area of the display 360 other than the navigation bar area 610 while displaying the second indicator 613 for changing a display area in the navigation bar area 610, the electronic device 301 may display the first indicator 611 indicating the swipe gesture setting in the navigation bar area 610, as illustrated in FIG. 6A.

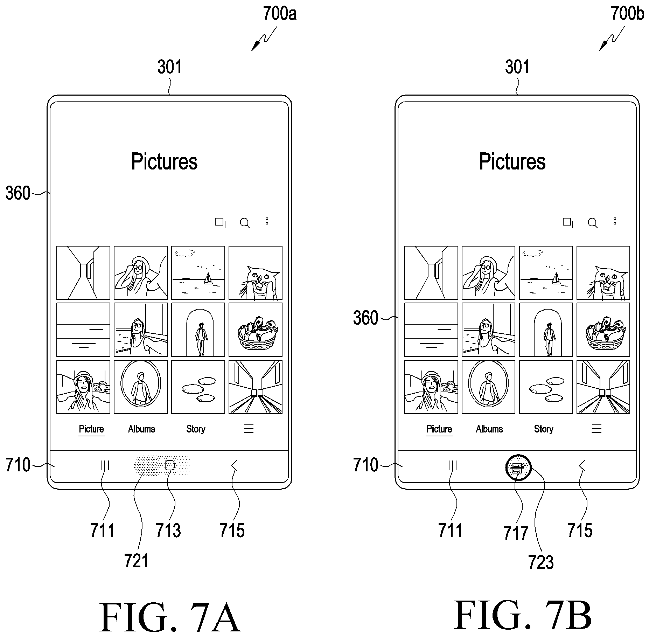

FIGS. 7A to 7C are diagrams 700a to 700c illustrating an operation of adjusting the size of a display in an electronic device according to various embodiments.

Referring to FIG. 7A, in the second state (e.g., the second state of FIG. 2B) in which the display 360 is partially inserted into or partially exposed from the housing (e.g., the first structure 120 of FIGS. 1A and 1B) and thus has the second size, the electronic device 301 may display a first view of a picture application including a plurality of pictures on the display 360 according to execution of the picture application, and display a plurality of buttons including a recent app button 711, a home button 713, and a back button 715 in a navigation bar area 710 of the display 360. Upon detection of a first gesture (e.g., left swipe) 721 on the home button 713 among the plurality of buttons displayed in the navigation bar area 710, the electronic device 301 may display a plurality of buttons including the recent app button 711, a control button 717, and the back button 715 in the navigation bar area 710 by releasing the display of the home button 713 and displaying the control button 717 in the navigation bar area 710, as illustrated in FIG. 7B.

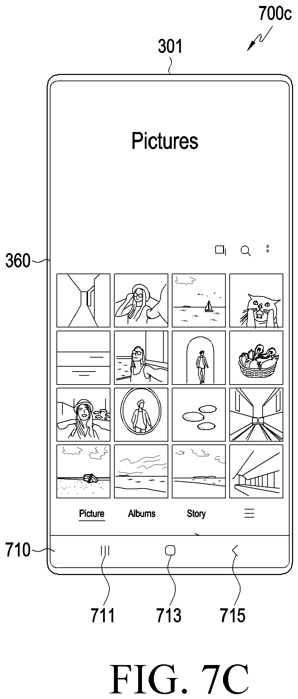

Referring to FIG. 7B, the electronic device 301 may switch the display to the third state (e.g., the third state of FIG. 2C) in which the display has the third size by changing the size of the display 360 as illustrated in FIG. 7C, based on a user input 723 to the control button 717 in the navigation bar area 710. Upon identification that the size of the display 360 has been changed to the third size, the electronic device 301 may display a first view which includes more pictures on the display 360 having the third size than when the display has the second size, and release the display of the control button 717 in the navigation bar area 710.

The electronic device 301 may display the plurality of buttons including the recent app button 711, the home button 713, and the back button 715 in the navigation bar area 710 by releasing the display of the control button 717 and displaying the home button 713 in the navigation bar area 710 as illustrated in FIG. 7C.

FIGS. 8A to 8F are diagrams 800a to 800f illustrating an operation of adjusting the size of a display in an electronic device according to various embodiments.

Referring to FIG. 8A, when the display 360 displays a first view of an application and a navigation bar area 810 is set to button display in the second state (e.g., the second state of FIG. 2B) in which the display 360 is partially inserted into or partially exposed from the housing (e.g., the first structure 120 of FIGS. 1A and 1B) and thus has the second size, the electronic device 301 may display a plurality of buttons including a recent app button 811, a home button 813, and a back button 815 in the navigation bar area 810 of the display 360. Upon identification of switching of the application from the first view to a second view (or such as identification of a new view being displayed due to execution of an application), the electronic device 301 may identify whether the condition for changing a display size is satisfied based on attribute information about the second view. Upon identification of a specified display size in which the second view is to be displayed as the third size of the display based on the attribute information about the second view, the electronic device 301 may identify that the condition for changing a display size is satisfied because the specified third size of the display in which the second view is to be displayed does not match the second size that is the current size of the display. The electronic device 301 may provide a visual effect that the navigation bar area 810 rolls away to disappear and thecontrol area 830 newly appears while the navigation bar area 810 is disappearing, based on the satisfaction of the condition, as illustrated in FIGS. 8B and 8C. Incertain embodiments, the navigation bar area 810 may roll away in a direction which is indicative of the direction in which the size of the display will change if a user input to change a display size to the specified display size is received. For instance, in a case where the display size will increase as the electronic device 301 switches from the second state to the third state (i.e., the display will appear to expand vertically), the navigation bar area may roll away in an upwards direction such that the control area 830 appears as shown in FIG. 8B. The visual effect may therefore provide a guide (for a user) as to potentially ensuing operations of the electronic device (e.g., by indicating the direction of display size change if a user input for changing the size is provided to a second button 833 as described below).

Referring to FIG. 8C, the electronic device 301 may display the control area 830 including a first button 831 for stopping changing of a display size, a second button 833 for changing a display size in correspondence with a specified display size in which a view is to be displayed, and a third button 835 for changing to a maximum display size or a minimum display size. Upon identification of a user input 871 to the second button 833, the electronic device 301 may switch the display to the third state (e.g., the third state of FIG. 2C) in which the display has the third size by changing the size of the display 360, as illustrated in FIG. 8D. Upon identification that the size of the display 360 has been changed to the third size, the electronic device 301 may provide a visual effect that the control area 830 rolls away to disappear and the navigation bar area 810 appears again while the control area 830 is disappearing, as illustrated in FIGS. 8E and 8F.

While the navigation bar area set to button display has been described with reference to FIGS. 8A to 8F, by way of example, the same operation may also be performed in a navigation bar area set to swipe gesture display.

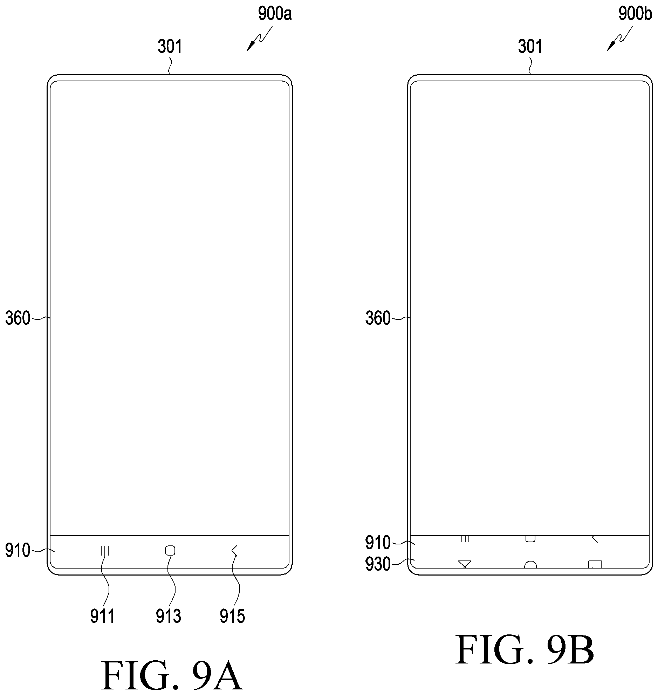

FIGS. 9A to 9F are diagrams 900a to 900f illustrating an operation of adjusting the size of a display in an electronic device according to various embodiments.

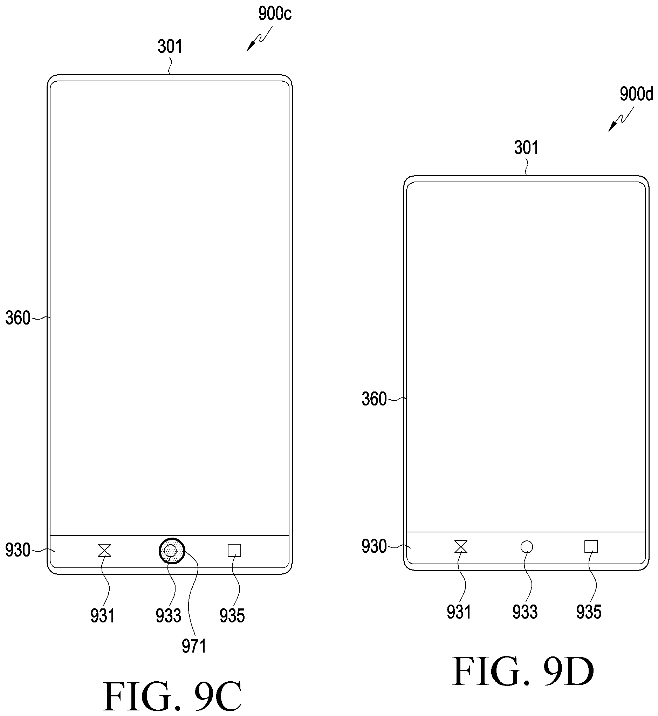

Referring to FIG. 9A, when the display 360 displays a first view of an application and a navigation bar area 910 is set to button display in the second state (e.g., the second state of FIG. 2B) in which the display 360 is partially inserted into or partially exposed from the housing (e.g., the first structure 120 of FIGS. 1A and 1B) and thus has the second size, the electronic device 301 may display a plurality of buttons including a recent app button 911, a home button 913, and a back button 915 in the navigation bar area 910 of the display 360. Upon identification of switching of the application from the first view to a second view, the electronic device 301 may identify whether the condition for changing a display size is satisfied based on attribute information about the second view. Upon identification of a specified display size in which the second view is to be displayed as the third size of the display based on the attribute information about the second view, the electronic device 301 may identify that the condition for changing a display size is satisfied because the specified third size of the display in which the second view is to be displayed does not match the second size that is the current size of the display. The electronic device 301 may provide a visual effect that the navigation bar area 910 rolls away to disappear and a control area 930 newly appears while the navigation bar area 910 is disappearing, based on the satisfaction of the condition, based on the satisfaction of the condition, as illustrated in FIGS. 9B and 9C.

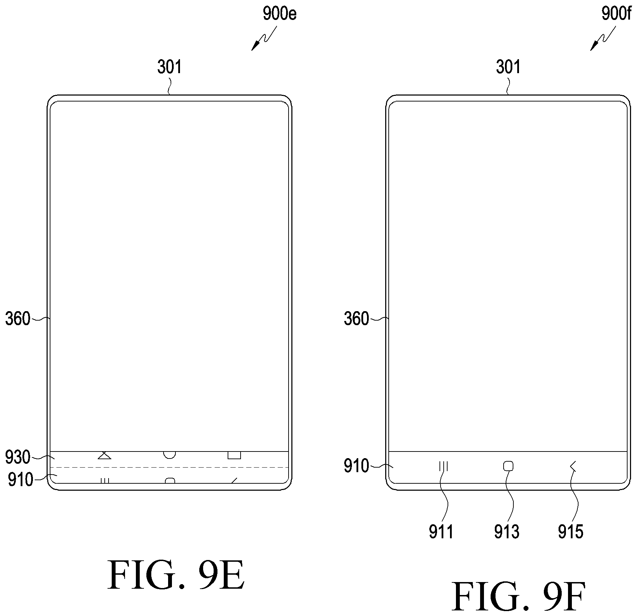

Referring to FIG. 9C, the electronic device 301 may display the control area 930 including a first button 931 for stopping changing of a display size, a second button 933 for changing a display size in correspondence with a specified display size in which a view is to be displayed, and a third button 935 for changing to a maximum display size or a minimum display size. Upon identification of a user input 971 to the second button 933, the electronic device 301 may switch the display to the first state (e.g., the first state of FIG. 2A) in which the display has the first size by changing the size of the display 360, as illustrated in FIG. 9D. Upon identification that the size of the display 360 has been changed to the first size, the electronic device 301 may provide a visual effect that the control area 930 rolls away to disappear and the navigation bar area 910 appears again while the control area 930 is disappearing, as illustrated in FIGS. 9E and 9F.

While the navigation bar area set to button display has been described with reference to FIGS. 9A to 9F, by way of example, the same operation may also be performed in a navigation bar area set to swipe gesture display.

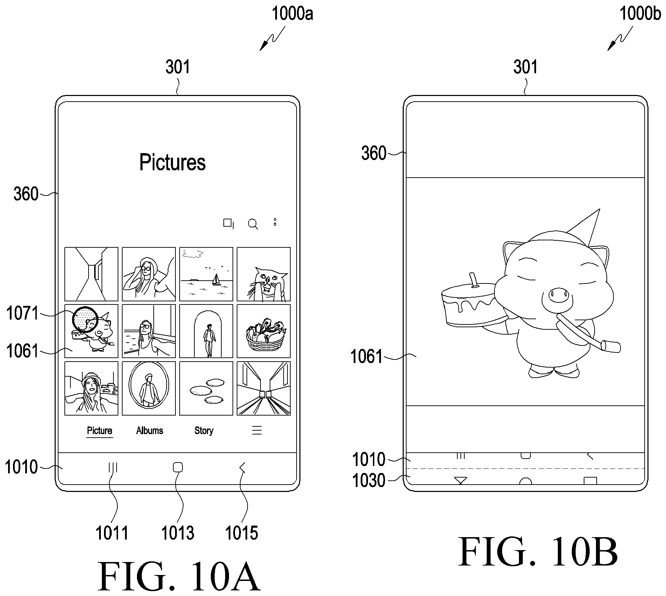

FIGS. 10A to 10C are diagrams 1000a to 1000c illustrating an operation of adjusting the size of a display in an electronic device according to various embodiments.

Referring to FIG. 10A, while displaying a plurality of buttons including a recent app button 1011, a home button 1013, and a back button 1015 in a navigation bar area 1010 of the display in the second state (e.g., the second state of FIG. 2B) in which the display 360 is partially inserted into or partially exposed from the housing (e.g., the first structure 120 of FIGS. 1A and 1B) and thus has the second size, the electronic device 301 may display a first view of a picture application including a plurality of pictures according to execution of the picture application. Upon identification of a user input 1071 for selecting a first picture 1061 from among the plurality of pictures corresponding to the first view, the electronic device 301 may display a second view of the picture application, in which the first picture 1061 may be displayed on the display 360, as illustrated in FIG. 10B.

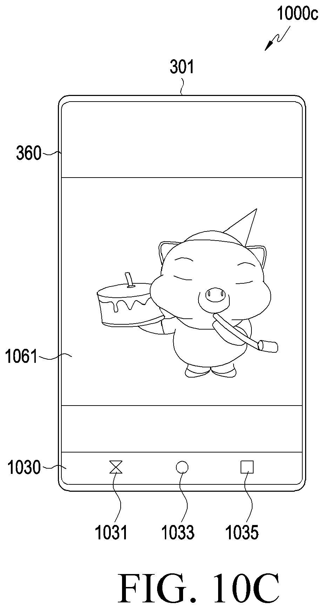

Referring to FIG. 10B, the electronic device 301 may identify whether the condition for changing a display size is satisfied based on attribute information about the second view. Upon identification of a specified display size in which the second view is to be displayed as the first size of the display based on the attribute information about the second view, the electronic device 301 may identify that the condition for changing a display size is satisfied because the specified first size of the display in which the second view is to be displayed does not match the second size that is the current size of the display. The electronic device 301 may provide a visual effect that the navigation bar area 1010 rolls away to disappear and a control area 1030, which includes a first button 1031 for stopping changing of a display size, a second button 1033 for changing a display size in correspondence with a specified display size in which a view is to be displayed, and a third button 1035 for changing to a maximum display size or a minimum display size, newly appears while the navigation bar area 1010 is disappearing, based on the satisfaction of the condition, based on the satisfaction of the condition, as illustrated in FIGS. 10B and 10C.

FIGS. 11A to 11D are diagrams 1100a to 1100d illustrating an operation of adjusting the size of a display in an electronic device according to various embodiments.

Referring to FIG. 11A, while displaying a plurality of buttons including a recent app button 1111, a home button 1113, and a back button 1115 in a navigation bar area 1110 of the display 360 in the second state (e.g., the second state of FIG. 2B) in which the display 360 is partially inserted into or partially exposed from the housing (e.g., the first structure 120 of FIGS. 1A and 1B) and thus has the second size, the electronic device 301 may display a first view on the display 360. The electronic device 301 may identify whether the condition for changing a display size is satisfied based on attribute information about the first view. Upon identification of a specified display size in which the first view is to be displayed as the third size of the display based on the attribute information about the first view, the electronic device 301 may identify that the condition for changing a display size is satisfied because the specified third size of the display in which the first view is to be displayed does not match the second size that is the current size of the display. The electronic device 301 may display a visual indicator 1150 at a boundary of the navigation bar area 1110 based on the satisfaction of the condition. Upon identification of a user input 1171 (e.g., a touch, an upward swipe, a tap, a drag etc.) to the visual indicator 1150, the electronic device 301 may display a control area 1110b including control buttons for changing a display size, as illustrated in FIG. 11B.

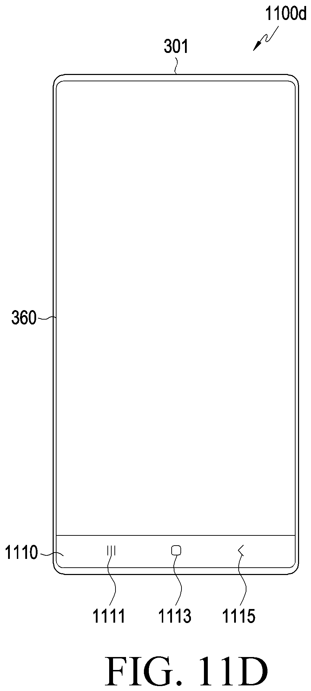

As illustrated in FIG. 11B, the electronic device 301 may expand the navigation bar area 1110, display the recent app button 1111, the home button 1113, and the back button 1115 in a first area 1110a of the expanded navigation bar area 1110, and provide a second area 1110b of the expanded navigation bar area 1110 as the control area. The electronic device 301 may display the control area including a first button 1131 for stopping changing of a display size, a second button 1133 for changing a display size in correspondence with a specified display size in which a view is to be displayed, and a third button 1135 for changing to a maximum display size or a minimum display size in the second area 1110b of the navigation bar area 1110. When failing to detect a user input to at least one of the plurality of buttons included in the control area for a predetermined time, the electronic device 301 may reduce the navigation bar area 1110 to a previous size and display only the recent app button 1111, the home button 1113, and the back button 1115 in the navigation bar area 1110 reduced to the previous size, as illustrated in FIG. 11A. Upon identification of a user input 1173 to the second button 1133, the electronic device 301 may switch the display to the third state (e.g., the third state of FIG. 2C) in which the display has the third size by changing the size of the display 360, as illustrated in FIG. 11C. Upon identification that the size of the display 360 has been changed to the third size, the electronic device 301 may release the display of the control area, as illustrated in FIG. 11D.

Referring to FIG. 11D, upon identification that the size of the display 360 has been changed to the third size, the electronic device 301 may release the display of the control area and display only the recent app button 1111, the home button 1113, and the back button 1115 in the navigation bar area 1110, by reducing the expanded navigation bar area 1110 to the previous size.

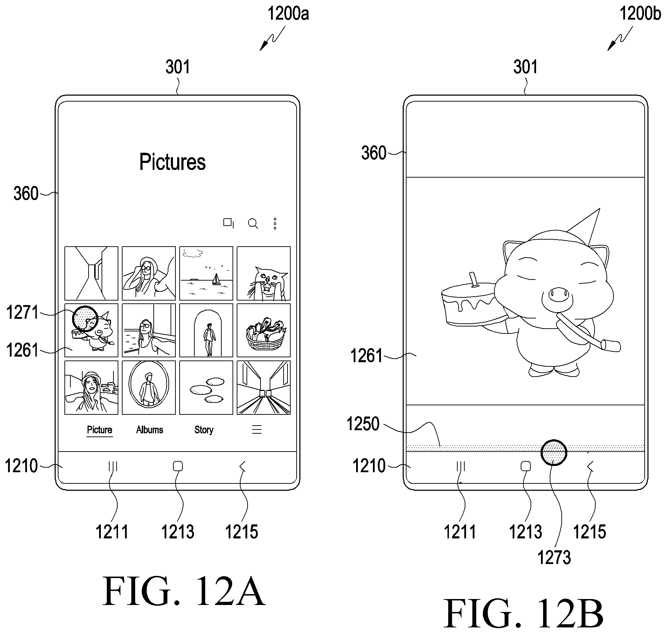

FIGS. 12A to 12C are diagrams 1200a to 1200c illustrating an operation of adjusting the size of a display in an electronic device according to various embodiments.

Referring to FIG. 12A, while displaying a plurality of buttons including a recent app button 1211, a home button 1213, and a back button 1215 in a navigation bar area 1210 of the display in the second state (e.g., the second state of FIG. 2B) in which the display 360 is partially inserted into or partially exposed from the housing (e.g., the first structure 120 of FIGS. 1A and 1B) and thus has the second size, the electronic device 301 may display a first view of a picture application including a plurality of pictures on the display 360 according to execution of the picture application. Upon identification of a user input 1271 for selecting a first picture 1261 from among the plurality of pictures corresponding to the first view, the electronic device 301 may display a second view of the picture application, in which the first picture 1261 may be displayed on the display 360, as illustrated in FIG. 12B.

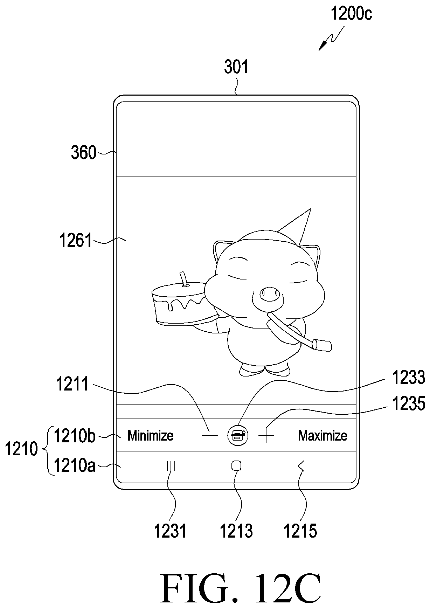

Referring to FIG. 12B, the electronic device 301 may identify whether the condition for changing a display size is satisfied based on attribute information about the second view. Upon identification of a specified display size in which the second view is to be displayed as the first size of the display based on the attribute information about the second view, the electronic device 301 may identify that the condition for changing a display size is satisfied because the specified first size of the display in which the second view is to be displayed does not match the second size that is the current size of the display. The electronic device 301 may display a visual indicator 1250 at a boundary of the navigation bar area 1210 based on the satisfaction of the condition. Upon identification of a user input 1273 to the visual indicator 1250, the electronic device 301 may display a control area including control buttons for changing a display size, as illustrated in FIG. 12C.

As illustrated in FIG. 12C, the electronic device 301 may expand the navigation bar area 1210, display the recent app button 1211, the home button 1213, and the back button 1215 in a first area 1210a of the expanded navigation bar area 1210, and provide a second area 1210b of the expanded navigation bar area 1210 as the control area. The electronic device 301 may display the control area including a first button 1231 for stopping changing of a display size, a second button 1233 for changing a display size in correspondence with a specified display size in which a view is to be displayed, and a third button 1235 for changing to a maximum display size or a minimum display size in the second area 1210b of the navigation bar area 1210.

FIGS. 13A to 13C are diagrams 1300a to 1300C illustrating an operation of adjusting the size of a display in an electronic device according to various embodiments.

Referring to FIG. 13A, the electronic device 301 may display a first view of an application on the display 360 according to execution of the application, and identify whether the condition for changing a display is satisfied based on attribute information about the first view.When determining that a specified display size in which the first view is to be displayed does not match a current size of the display based on the attribute information about the first view, the electronic device 301 may identify that the condition for changing a display size is satisfied. The electronic device 301 may display the indicator 1351 for changing the display in a navigation bar area 1310 including a recent app button 1311, a home button 1313, and a back button 1315 based on the satisfaction of the condition. Upon identification of a user input 1371 to the indicator 1351 for changing the display, the electronic device 301 may release the display of the indicator 1351 for changing the display in the navigation bar area 1310, and display the control bar 1353 for changing a display size in a first size in a partial area of the display 360 other than the navigation bar area 1310, as illustrated in FIG. 13B.In certain embodiments of the present disclosure, the indicator 1351 may be displayed in a predetermined area on the display, such as the navigation bar area 1310, without identifying that the condition for changing a display size is satisfied. For example, the indicator 1351 may simply be included as part of the navigation bar area, or may be displayed in response to another trigger such as a user input to display the indicator 1351 or to include the indicator 1351 in the predetermined area.

Referring to FIG. 13B, when failing to detect a user input to the control bar 1353 for a predetermined time while displaying the control bar 1353 in the first size in the partial area of the display 360, the electronic device 301 may release the display of the control bar 1353, and display the navigation bar area 1310 including the recent app button 1311, the home button 1313, the back button 1215, and the indicator 1351 for changing the display, as illustrated in FIG. 13A. Upon detection of a second gesture (e.g., upward swipe) 1373 on the control bar 1353 while displaying the control bar 1353 in the first size in the partial area of the display 360, the electronic device 301 may enlarge the control bar 1353 to a second size larger than the first size (e.g., in horizontal and/or vertical directions) and display the control bar 1355 enlarged to the second size, as illustrated in FIG. 13C.

Referring to FIG. 13C, when failing to detect a user input to the control bar 1355 for a predetermined time while displaying the control bar 1355 in the second size in the partial area of the display 360, the electronic device 301 may release the display of the control bar 1355, and display the navigation bar area 1310 including the recent app button 1311, the home button 1313, the back button 1215, and the indicator 1351 for changing the display, as illustrated in FIG. 13A. While displaying the control bar 1355 in the second size in the partial area of the display 360, the electronic device 301 may change (or adjust) the size of the display in correspondence with a user input for moving an up pointer or a down pointer included in the enlarged control bar 1355 of the second size. Upon completion of changing (or adjusting) the size of the display using the control bar 1355, the electronic device 301 may release the display of the control bar 1355.

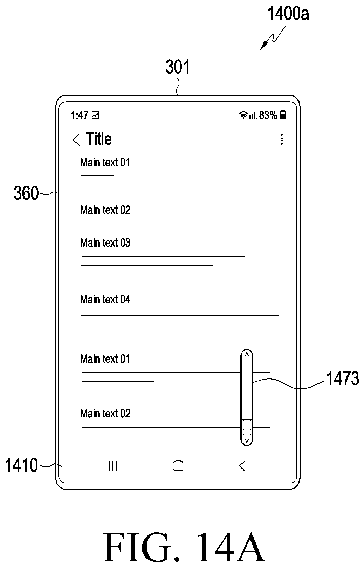

FIGS. 14A to 14C are diagrams 1400a to 1400c illustrating an operation of adjusting the size of a display in an electronic device according to various embodiments.

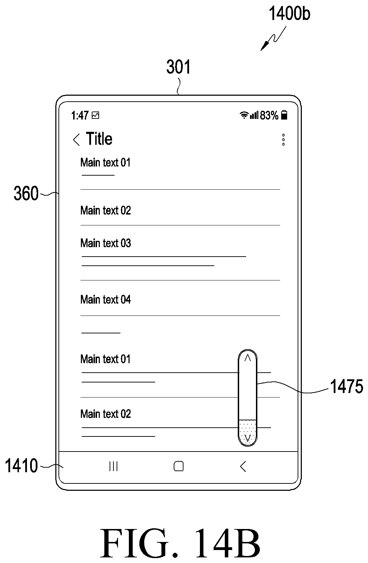

Referring to FIG. 14A, in the second state (e.g., the second state of FIG. 2B) in which the display 360 is partially inserted into or partially exposed from the housing (e.g., the first structure 120 of FIGS. 1A and 1B) and thus has the second size, the electronic device 301 may display a first view of an application showing a list on the display 360 according to execution of the application, and identify whether the condition for changing a display is satisfied based on attribute information about the first view.When determining that a specified third size in which the first view is to be displayed does not match the current second size of the display based on the attribute information about the first view, the electronic device 301 may identify that the condition for changing a display size is satisfied. The electronic device 301 may additionally display an indicator for changing the display in a navigation bar area 1410 including a recent app button, a home button, and a back button based on the satisfaction of the condition. The electronic device 301 may release the display of the indicator for changing the display in the navigation bar area 1410, and display a control bar 1473 for changing a display size in a first size in a partial area of the display 360 other than the navigation bar area 1410, based on a user input to the indicator for changing the display. Upon detection of a second gesture (e.g., upward swipe) on the control bar 1473 while displaying the control bar 1473 in the first size in the partial area of the display 360, the electronic device 301 may enlarge the control bar 1453 to a second size larger than the first size and display a control bar 1475 enlarged to the second size, as illustrated in FIG. 14B.

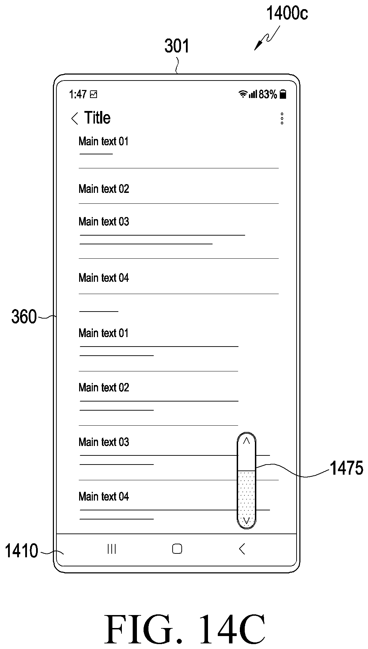

Referring to FIG. 14B, upon identification of a user input for moving an up pointer out of the up pointer and a down pointer included in the enlarged control bar 1475 of the second size while displaying the control bar 1475 in the second size in the partial area of the display 360, the electronic device 301 may change (or adjust) the size of the display, as illustrated in FIG. 14C.

Referring to FIG. 14C, the electronic device 301 may switch the display to the third state (e.g., the third state of FIG. 2C) in which the display has the third size, by changing the size of the display 360. The electronic device 301 may visually display the movement of the up pointer even inside the control bar 1475, and release the display of the control bar 1475 a predetermined time later.

FIGS. 15A to 15D are diagrams 1500a to 1500d illustrating an operation of adjusting the size of a display in an electronic device according to various embodiments.

Referring to FIG. 15A, in the second state (e.g., the second state of FIG. 2B) in which the display 360 is partially inserted into or partially exposed from the housing (e.g., the first structure 120 of FIGS. 1A and 1B) and thus has the second size, the electronic device 301 may display a first view of an application on the display 360 according to execution of the application, and identify whether the condition for changing a display is satisfied based on attribute information about the first view.When determining that a specified third size in which the first view is to be displayed does not match the current second size of the display based on the attribute information about the first view, the electronic device 301 may identify that the condition for changing a display size is satisfied. The electronic device 301 may display theindicator1551 for changing the display in the navigation bar area 1510, as illustrated in FIG. 15B.

Referring to FIG. 15B, the electronic device 301 may additionally display the indicator 1551 for changing the display in the navigation bar area 1510 including a recent app button 1511, a home button 1513, and a back button 1515. Upon identification of a user input 1571 to the indicator 1551 for changing the display, the electronic device 301 may release the display of the indicator 1571 for changing the display in the navigation bar area 1510, and display a control area 1553 in a partial area of the display 360 other than the navigation bar area 1510.

Referring to FIG. 15C, the electronic device 301 may include and display a control bar 1553a for changing a display size and a cancel button 1553 for canceling a display size change in the control area 1553. Upon detection of a second gesture (e.g., upward swipe) 1573 in the control bar 1573 included in the control area 1553, the electronic device 301 may change the size of the display 360, as illustrated in FIG. 15D.In some examples, the control bar 1552a may indicate a percentage representing a degree to which the display is inserted or extended, as illustrated in FGI. 15C. Optionally, a user may enter a percentage to which the display size should be changed, resulting in the electronic device changing the size of the display to correspond to the input size.

Referring to FIG. 15D, the electronic device 301 may switch the display to the third state (e.g., the third state of FIG. 2C) in which the display has the third size, by changing the size of the display 360. Upon identification that the size of the display has been changed, the electronic device 301 may release the display of the control bar 1553.

Referring to FIG. 15C, upon identification of a user input 1575 to the cancel button 1553b for canceling a display size change included in the control area 1553, the electronic device 301 may display only the recent app button 1511, the home button 1513, and the back button 1515 in the navigation bar area 1510, as illustrated in FIG. 15A.

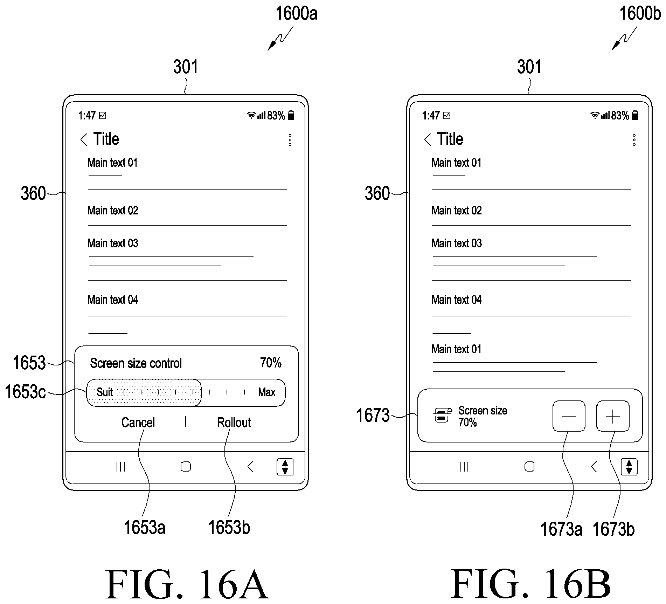

FIGS. 16A and 16B are diagrams 1600a and 1600b illustrating an operation of adjusting the size of a display in an electronic device according to various embodiments.

Referring to FIG. 16A, the electronic device 301 may display a first view of an application showing a list on the display 360 according to execution of the application. When the condition for changing a display is satisfied based on attribute information about the first view, the electronic device 301 may display a control area 1653 in a partial area of the display 360 other than a navigation bar area. The electronic device 301 may include and display a cancel button 1653a for canceling a display size change, a change button 1653b for enabling a control bar for changing a display size, and a control bar 1653c for changing a display size in the control area 1653.In an example, the control area further indicates a size to which the display is currently extended, i.e., a percentage representative of the size of the display in the current state of the electronic device.

Referring to FIG. 16B, the electronic device 301 may display a first view of an application showing a list on the display 360 according to execution of the application. When the condition for changing a display is satisfied based on attribute information about the first view, the electronic device 301 may display a control area 1673 in a partial area of the display 360 other than a navigation bar area. The electronic device 301 may include and display an enlarge button 1673a for increasing a display size and a contract button 1673b for decreasing a display size in the control area 1673.In an example, the control area further indicates a size to which the display is currently extended, i.e., a percentage representative of the size of the display in the current state of the electronic device.

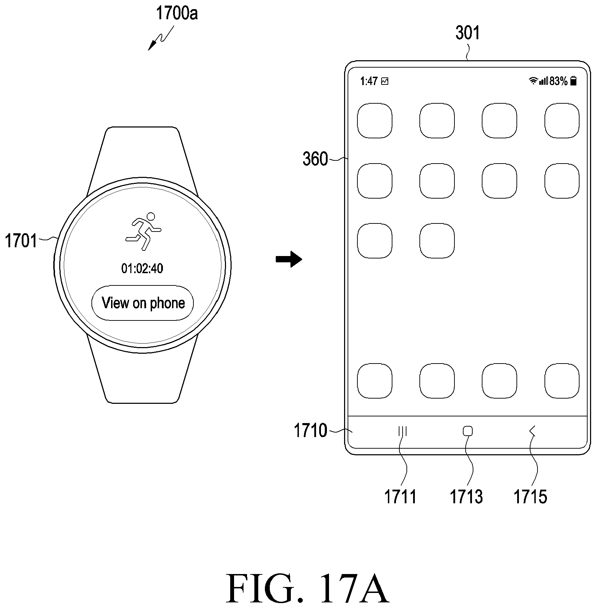

FIGS. 17A to 17D are diagrams 1700a to 1700d illustrating an operation of adjusting the size of a display in an electronic device according to various embodiments.

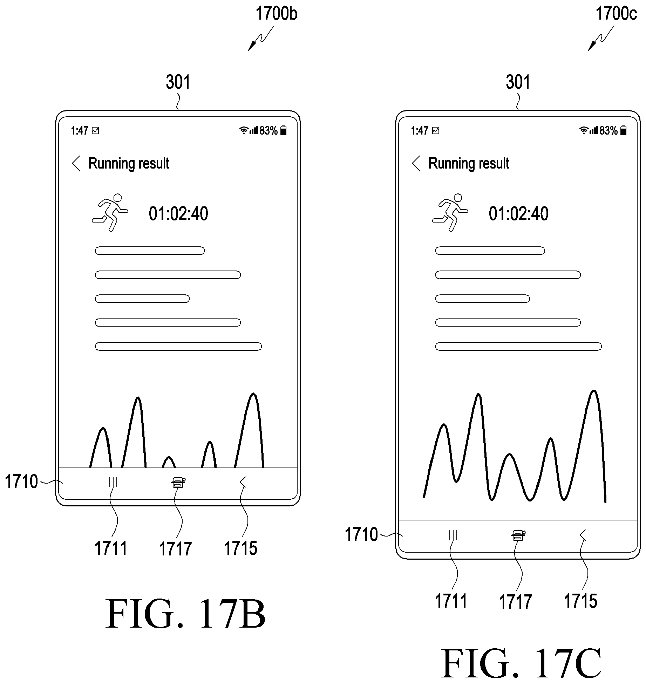

Referring to FIG. 17A, while displaying a home screen on the display 360 and displaying a plurality of buttons including a recent app button 1711, a home button 1713, and a back button 1715 in a navigation bar area 1710 of the display 360 in the second state (e.g., the second state of FIG. 2B) in which the display 360 is partially inserted into or partially exposed from the housing (e.g., the first structure 120 of FIGS. 1A and 1B) and thus has the second size, the electronic device 301 may receive data (e.g., exercise data from an external electronic device 1701 (e.g., a wearable electronic device) connected to the electronic device 301 for communication. For example, an input to the external electronic device 1701, e.g., an input to the "View on phone" item displayed by external electronic device 1701, may result in the external electronic device 1701 transmitting data (e.g., the exercise data) to the electronic device 301. The electronic device 301 may identify whether information about a previous display size that the user of the electronic device 301 used to display the data (e.g., exercise data) has been stored as history information about the user. Upon identification that the information about the previous display size that the user used to display the data has been stored as the history information about the user, the electronic device 301 may compare the information about the display size (e.g., the third size) based on the history information about the user with information about a current size (e.g., the first size) of the display 360. Alternatively, the electronic device 301 may compare information about a display size (e.g., the third size) set to display data received from the external electronic device 1701 with the information about the current size (e.g., the first size) of the display 360. When the information does not match as a result of the comparison, the electronic device 301 may identify that the condition for changing a display size is satisfied. As illustrated in FIG. 17B, the electronic device 301 may display the data (e.g., exercise data) in a partial area of the display 360 and provide a control button 1717 for changing a display size.

As illustrated in FIG. 17B, the electronic device 301 may display the data (e.g., exercise data) in the partial area of the display 360, and display the recent app button 1711, the control button 1717, and the back button 1715 in the navigation bar area 1710 by releasing the display of the home button 1713 and displaying the control button 1717 for changing a display size in the navigation bar area 1710. While changing the size of the display to the third size based on a user input to the control button 1717, the electronic device 301 may display the recent app button 1711, the control button 1717, and the back button 1715 in the navigation bar area 1710, as illustrated in FIG. 17C.

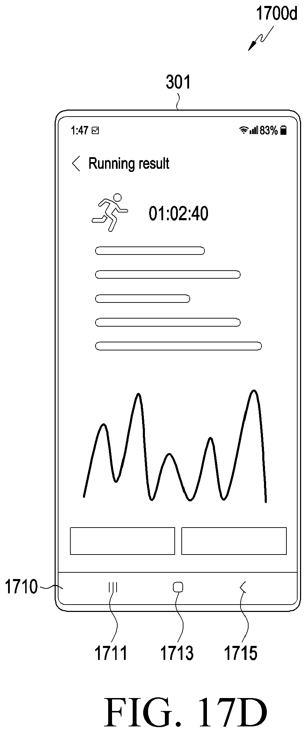

As illustrated in FIG. 17D, upon completion of changing the size of the display to the third size, the electronic device 301 may release the display of the control button 1717 and display the recent app button 1711, the home button 1713, and the back button 1715 in the navigation bar area 1710.

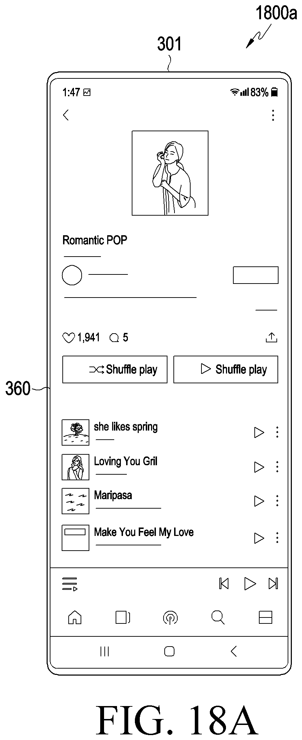

FIGS. 18A to 18Care diagrams 1800a to 1800c illustrating an operation of adjusting the size of a display in an electronic device according to various embodiments.

As illustrated in FIG. 18A, the electronic device 301 may turn on a screen of the display 360 in the third state (e.g., the third state of FIG. 2C) in which the display 360 is fully exposed from the housing (e.g., the first structure 120 of FIGS. 1A and 1B) and thus has the third size.

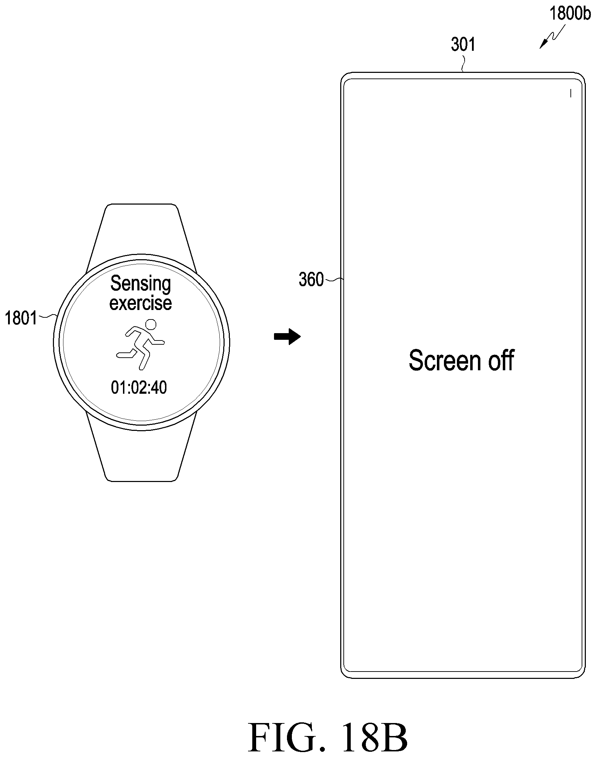

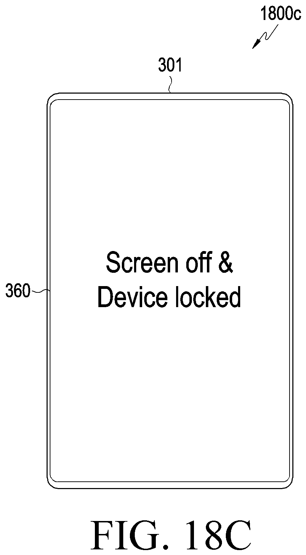

As illustrated in FIG. 18B, while turning off the screen of the display 360 due to failure in detecting a user input to the electronic device 301, the electronic device 301 may receive information indicating an exercise state as an operation state from an external electronic device 1801 worn on the user of the electronic device. When the screen of the display 360 is kept off due to failure in detecting a user input to the electronic device 301 after the reception of the information indicating the exercise state from the external electronic device 1801, the electronic device 301 may switch the display 360 to the first state (e.g., the first state of FIG. 2A) in which the display has the first size by changing the size of the display 360, as illustrated in FIG. 18C.

As illustrated in FIG. 18C, when the screen of the display 360 is kept off due to failure in detecting a user input to the electronic device 301, the electronic device 301 may switch the display 360 to the first state (e.g., the first state of FIG. 2A) in which the display has the first size by changing the size of the display 360, and lock the electronic device 301 due to the continuous screen-off of the display 360.

For example, in detecting that the user may be exercising according to the reception of theinformation indicating the exercise state, the electronic device 301 may assume that a display size corresponding to that of the third state is not necessary at the time, and so automatically reduce the size of the display screen (e.g., to a minimum size). This may improve the portability of the electronic device 301.

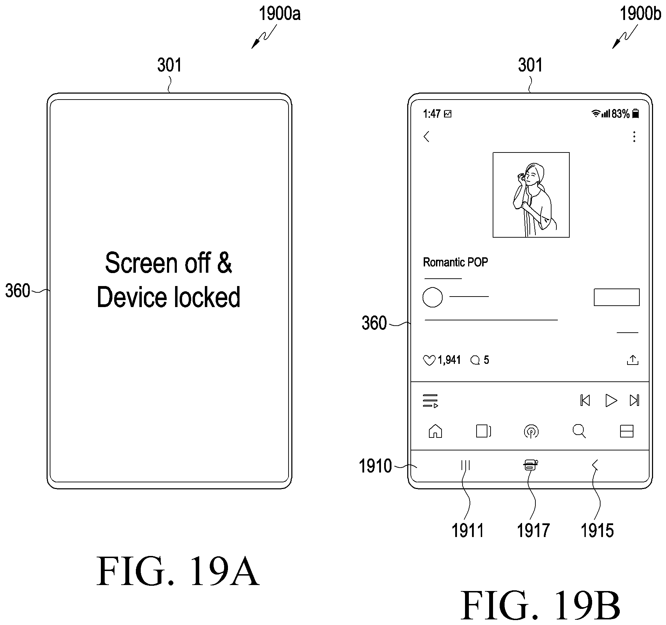

FIGS. 19A to 19D are diagrams 1900a to 1900d illustrating an operation of adjusting the size of a display in an electronic device according to various embodiments.

Referring to FIG. 19A, upon receipt of information indicating an exercise state from an external electronic device (e.g., a wearable electronic device) worn on the user of the electronic device 301 and connected to the electronic device 301 for communication, the electronic device 301 may switch or keep the display 360 to or in the first state (e.g., the first state of FIG. 2A) in which the display 360 is fully inserted into the housing (e.g., the first structure 120 of FIGS. 1A and 1B) and thus has the first size, turn off the screen of the display 360, and lock the electronic device 301. Upon identification that a music application has been selected while detecting that the external electronic device is in the exercise state, the electronic device 301 may display a first view of the music application, in which a song list of a specific singer may be displayed, on the display 360 of the first size, as illustrated in FIG. 19B. As illustrated in FIG. 19B, while the electronic device 301 is detecting that the external electronic device worn on the user of the electronic device is in the exercise state, the electronic device 301 may keep the display 360 in the first state (e.g., the first state of FIG. 2A) in which the display has the first size, even when the user uses the electronic device 301.The electronic device 301 may display a recent app button 1911, a control button 1917, and a back button 1915 in a navigation bar area 1910.

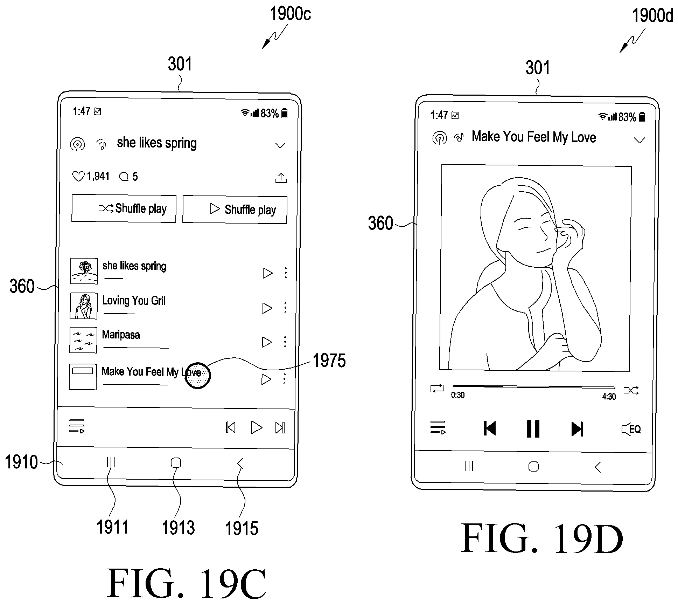

As illustrated in FIG. 19C, upon identification of occurrence of a touch gesture 1975 including a scroll in the first view of the music application, in which the song list of the specific singer may be displayed, displayed on the display 360, the electronic device 301 may release the display of the control button and display the recent app button 1911, a home button 1913, and the back button 1915 in the navigation bar area 1910 of the display 360. Upon identification that a specific song has been selected in the first view of the music application, in which the song list of the specific singer may be displayed, displayed on the display 360, the electronic device 301 may display a second view of the music application, in which playback of the selected song may be displayed, as illustrated in FIG. 19D.

As illustrated in FIG. 19D, the electronic device 301 may display the second view of the music application, in which playback of the selected song may be displayed, while keeping the display 360 in the first state (e.g., the first state of FIG. 2A) in which the display 360 has the first size.

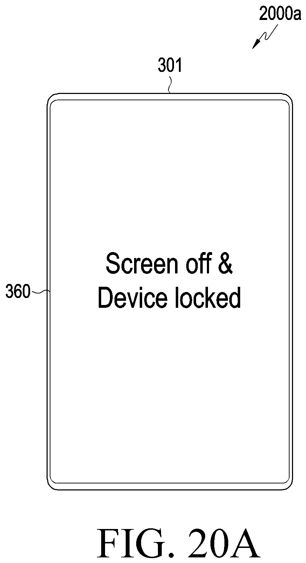

FIGS. 20A to 20D are diagrams 2000a to 2000d illustrating an operation of adjusting the size of a display in an electronic device according to various embodiments.

Referring to FIG. 20A, upon receipt of information indicating an exercise state from an external electronic device (e.g., a wearable electronic device) worn on the user of the electronic device 301 and connected to the electronic device 301 for communication, the electronic device 301 may switch or keep the display 360 to or in the first state (e.g., the first state of FIG. 2A) in which the display 360 is fully inserted into the housing (e.g., the first structure 120 of FIGS. 1A and 1B) and thus has the first size. For example, in a state in which the screen of the display 360 is off and the electronic device 301 is locked, the electronic device 301 may receive the information indicating the exercise state from the external electronic device (e.g., the wearable electronic device).

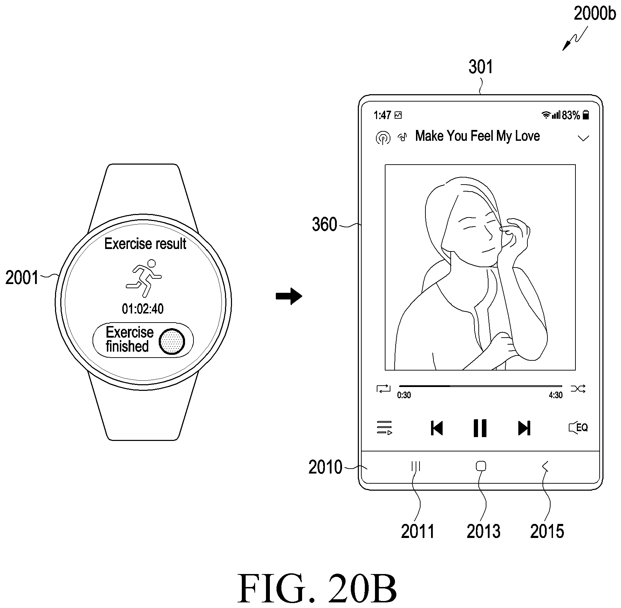

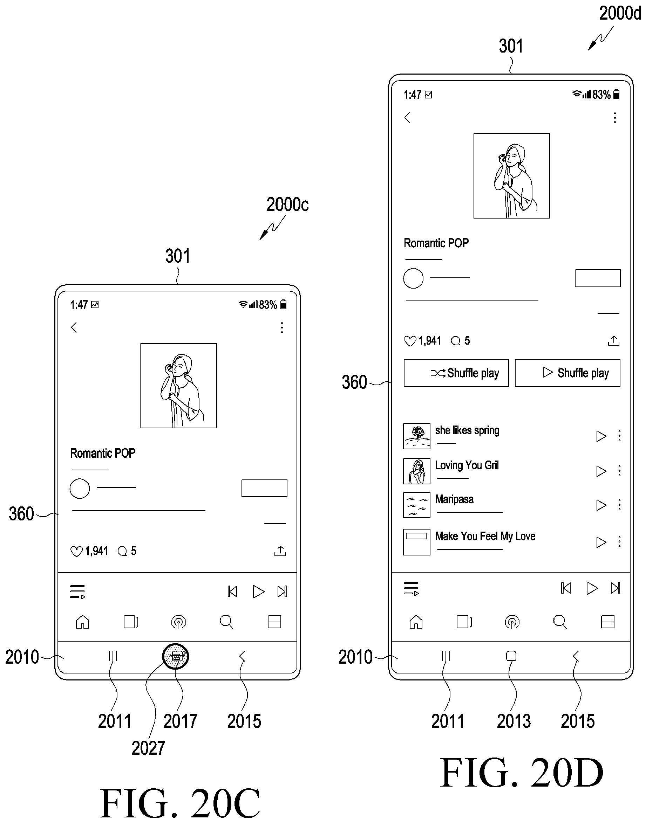

As illustrated in FIG. 20B, after receiving information indicating that exercise is finished from an external electronic device 2001, the electronic device 301 may display a first view of a music application, in which playback of a song of a specific singer may be displayed, on the display 360 according to the execution of the music application. While displaying the first view on the display 360, the electronic device 301 may display a plurality of buttons including a recent app button 2011, a home button 2013, and a back button 2015 in a navigation bar area 2010 of the display 360. Upon selection of display of a song list of the specific singer, the electronic device 301 may display a second view of the music application, in which a song list of the specific singer may be displayed, on the display 360, as illustrated in FIG. 20C.

As illustrated in FIG. 20C, when or while displaying the second view on the display 360, the electronic device 301 may identify whether the condition for changing a display size is satisfied based on attribute information about the second view. Upon identification of a specified display size in which the second view is to be displayed as the third size of the display based on the attribute information about the second view, the electronic device 301 may identify that the condition for changing a display size is satisfied because the specified third size of the display in which the second view is to be displayed does not match the first size that is a current size of the display. The electronic device 301 may display a plurality of buttons including the recent app button 2011, a control button 2017, and the back button 2015 in a navigation bar area 2010 of the display 360 by releasing the display of the home button 2013 and displaying the control button 2017 in the navigation bar area 2010. As illustrated in FIG. 20D, the electronic device 301 may switch the display 360 to the third state (e.g., the third state of FIG. 2C) in which the display has the third size, by changing the size of the display 360, based on a user input 2027 to the control button 2017.

Referring to FIG. 20D, upon identification that the size of the display 360 has been changed to the specified third size in which the second view is to be displayed, the electronic device 301 may display the plurality of buttons including the recent app button 2011, the home button 2013, and the back button 2015 in the navigation bar area 2010 of the display 360 by releasing the display of the control button 2017 and displaying the home button 2013 in the navigation bar area 2010.

While the embodiments of the disclosure have been described in the context of an electronic device in which the length of a display is changed (or adjusted) in a longitudinal direction, the same thing may also be applied to an electronic device in which the length of a display is changed (or adjusted) in a latitudinal direction.

According to various embodiments, an electronic device (e.g., the electronic device 101 of FIGS. 1A to 1C), the electronic device 201 of FIGS. 2A to 2C, or the electronic device 301 of FIG. 3A) may include a first housing (e.g., the second structure 120 of FIGS. 1A to 1C), a second housing (e.g., the first structure 110 of FIGS. 1A to 1C) disposed to be movable with respect to the first housing and overlapping with at least part of the first housing, at least one processor and a driving module disposed inside the second housing, and a flexible display (e.g., the display 112 of FIGS. 1A to 1C or the display 360 of FIG. 3A)at least partially mounted on a surface of the second housing and at least partially exposed to an outside of the electronic device. Part of the flexible display may be configured to beinserted into or extended from the first housing according to driving of the driving module. The at least one processor (e.g., the processor 320 of FIG. 3A) may be configured to, when a condition for changing a size of the display is satisfied based on attribute information about a view of an application in displaying the view on the display, provide at least one control button for changing the size of the display.

According to various embodiments, the attribute information about the view may include information about a specified display size in which the view is to be displayed.

According to various embodiments, the processor may be configured to identify that the condition is satisfied, when the size of the display does not match a specified display size in which the view is to be displayed.

According to various embodiments, the processor may be configured to change the size of the display in correspondence with the attribute information about the view, based on a user input for selection of the control button.

According to various embodiments, the processor may be configured to release the display of the control button on the display, upon completion of changing the size of the display in correspondence with the attribute information about the view.

According to various embodiments, the processor may be configured to release the display of the control button, when a user input to the control button is not identified for a predetermined time.

According to various embodiments, the processor may be configured to, when the condition is satisfied, display at least one control button for changing the size of the display in a predetermined area of the display.

According to various embodiments, the processor may be configured to, when the condition is satisfied, to provide a visual effect that a predetermined area of the display disappears by rolling away and a control area including at least one control button for changing the size of the display is displayed.

According to various embodiments, the processor may be configured to, when the condition is satisfied, display a visual indicator at a boundary of a predetermined area of the display, and display a control area including at least one control button for changing the size of the display based on a user input to the visual indicator.

According to various embodiments, the processor may be configured to, when the condition is satisfied, display an indicator in a predetermined area of the display, and display a control bar for changing the size of the display based on a user input to the indicator.

It will be appreciated that the above-described embodiments may be combined with one another in each and every combination. That is, each and every combination of two or more of the above-described embodiments is envisaged and included within the present disclosure.

The above-described electronic device (e.g., the electronic device 101 of FIGS. 1A to 1C), the electronic device 201 of FIGS. 2A to 2C, or the electronic device 301 of FIG. 3A) may be configured identically or similarly to an electronic device 2101 describedbelow.

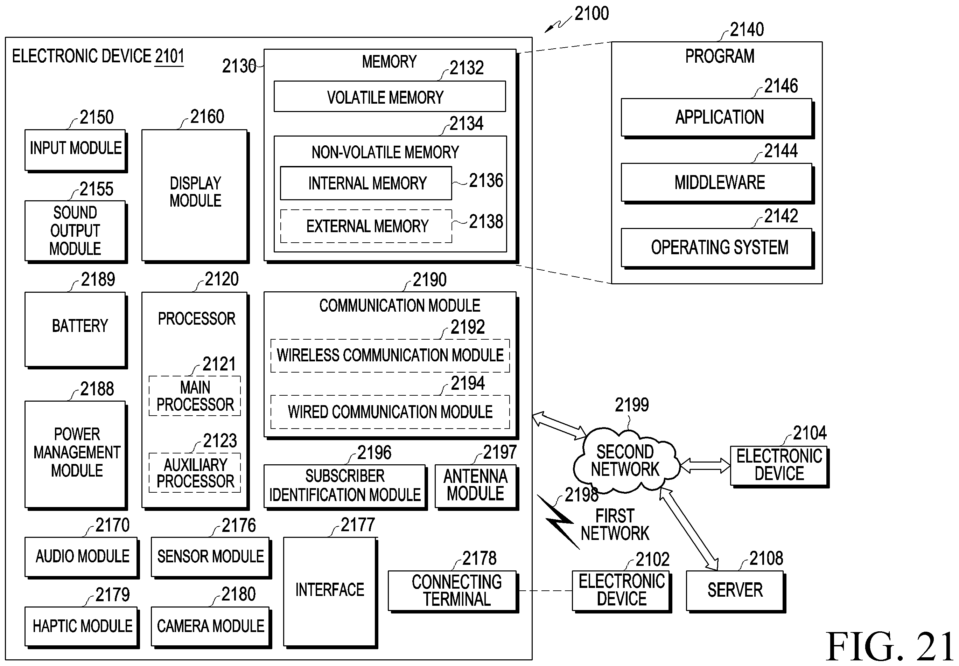

FIG. 21 is a block diagramillustratingthe electronic device 2101 in a network environment 2100according to various embodiments.

Referring to FIG. 21, the electronic device 2101 in the network environment 2100 may communicate with an electronic device 2102 via a first network 2198 (e.g., a short-range wireless communication network), or at least one of an electronic device 2104 or a server 2108 via a second network 2199 (e.g., a long-range wireless communication network). According to an embodiment, the electronic device 2101 may communicate with the electronic device 2104 via the server 2108. According to an embodiment, the electronic device 2101 may include a processor 2120, memory 2130, an input module 2150, a sound output module 2155, a display module 2160, an audio module 2170, a sensor module 2176, an interface 2177, a connecting terminal 2178, a haptic module 2179, a camera module 2180, a power management module 2188, a battery 2189, a communication module 2190, a SIM 2196, or an antenna module 2197. In some embodiments, at least one of the components (e.g., the connecting terminal 2178) may be omitted from the electronic device 2101, or one or more other components may be added in the electronic device 2101. In some embodiments, some of the components (e.g., the sensor module 2176, the camera module 2180, or the antenna module 2197) may be implemented as a single component (e.g., the display module 2160).

The processor 2120 may execute, for example, software (e.g., a program 2140) to control at least one other component (e.g., a hardware or software component) of the electronic device 2101 coupled with the processor 2120, and may perform various data processing or computation. According to one embodiment, as at least part of the data processing or computation, the processor 2120 may store a command or data received from another component (e.g., the sensor module 2176 or the communication module 2190) in volatile memory 2132, process the command or the data stored in the volatile memory 2132, and store resulting data in non-volatile memory 2134. According to an embodiment, the processor 2120 may include a main processor 2121 (e.g., a central processing unit (CPU) or an application processor (AP)), or an auxiliary processor 2123 (e.g., a graphics processing unit (GPU), a neural processing unit (NPU), an image signal processor (ISP), a sensor hub processor, or a communication processor (CP)) that is operable independently from, or in conjunction with, the main processor 2121. For example, when the electronic device 2101 includes the main processor 2121 and the auxiliary processor 2123, the auxiliary processor 2123 may be adapted to consume less power than the main processor 2121, or to be specific to a specified function. The auxiliary processor 2123 may be implemented as separate from, or as part of the main processor 2121.

The auxiliary processor 2123 may control at least some of functions or states related to at least one component (e.g., the display module 2160, the sensor module 2176, or the communication module 2190) among the components of the electronic device 2101, instead of the main processor 2121 while the main processor 2121 is in an inactive (e.g., sleep) state, or together with the main processor 2121 while the main processor 2121 is in an active state (e.g., executing an application). According to an embodiment, the auxiliary processor 2123 (e.g., an image signal processor or a communication processor) may be implemented as part of another component (e.g., the camera module 2180 or the communication module 2190) functionally related to the auxiliary processor 2123. According to an embodiment, the auxiliary processor 2123 (e.g., the neural processing unit) may include a hardware structure specified for artificial intelligence model processing. An artificial intelligence model may be generated by machine learning. Such learning may be performed, e.g., by the electronic device 2101 where the artificial intelligence is performed or via a separate server (e.g., the server 2108). Learning algorithms may include, but are not limited to, e.g., supervised learning, unsupervised learning, semi-supervised learning, or reinforcement learning. The artificial intelligence model may include a plurality of artificial neural network layers. The artificial neural network may be a deep neural network (DNN), a convolutional neural network (CNN), a recurrent neural network (RNN), a restricted boltzmann machine (RBM), a deep belief network (DBN), a bidirectional recurrent deep neural network (BRDNN), deep Q-network or a combination of two or more thereof but is not limited thereto. The artificial intelligence model may, additionally or alternatively, include a software structure other than the hardware structure.

The memory 2130 may store various data used by at least one component (e.g., the processor 2120 or the sensor module 2176) of the electronic device 2101. The various data may include, for example, software (e.g., the program 2140) and input data or output data for a command related thererto. The memory 2130 may include the volatile memory 2132 or the non-volatile memory 2134.

The program 2140 may be stored in the memory 2130 as software, and may include, for example, an operating system (OS) 2142, middleware 2144, or an application 2146.

The input module 2150 may receive a command or data to be used by another component (e.g., the processor 2120) of the electronic device 2101, from the outside (e.g., a user) of the electronic device 2101. The input module 2150 may include, for example, a microphone, a mouse, a keyboard, a key (e.g., a button), or a digital pen (e.g., a stylus pen).

The sound output module 2155 may output sound signals to the outside of the electronic device 2101. The sound output module 2155 may include, for example, a speaker or a receiver. The speaker may be used for general purposes, such as playing multimedia or playing record. The receiver may be used for receiving incoming calls. According to an embodiment, the receiver may be implemented as separate from, or as part of the speaker.

The display module 2160 may visually provide information to the outside (e.g., a user) of the electronic device 2101. The display module 2160 may include, for example, a display, a hologram device, or a projector and control circuitry to control a corresponding one of the display, hologram device, and projector. According to an embodiment, the display module 2160 may include a touch sensor adapted to detect a touch, or a pressure sensor adapted to measure the intensity of force incurred by the touch.

The audio module 2170 may convert a sound into an electrical signal and vice versa. According to an embodiment, the audio module 2170 may obtain the sound via the input module 2150, or output the sound via the sound output module 2155 or a headphone of an external electronic device (e.g., an electronic device 2102) directly (e.g., wiredly) or wirelessly coupled with the electronic device 2101.

The sensor module 2176 may detect an operational state (e.g., power or temperature) of the electronic device 2101 or an environmental state (e.g., a state of a user) external to the electronic device 2101, and then generate an electrical signal or data value corresponding to the detected state. According to an embodiment, the sensor module 2176 may include, for example, a gesture sensor, a gyro sensor, an atmospheric pressure sensor, a magnetic sensor, an acceleration sensor, a grip sensor, a proximity sensor, a color sensor, an infrared (IR) sensor, a biometric sensor, a temperature sensor, a humidity sensor, or an illuminance sensor.

The interface 2177 may support one or more specified protocols to be used for the electronic device 2101 to be coupled with the external electronic device (e.g., the electronic device 2102) directly (e.g., wiredly) or wirelessly. According to an embodiment, the interface 2177 may include, for example, a high definition multimedia interface (HDMI), a universal serial bus (USB) interface, a secure digital (SD) card interface, or an audio interface.

A connecting terminal 2178 may include a connector via which the electronic device 2101 may be physically connected with the external electronic device (e.g., the electronic device 2102).According to an embodiment, the connecting terminal 2178 may include, for example, a HDMI connector, a USB connector, a SD card connector, or an audio connector (e.g., a headphone connector).

The haptic module 2179 may convert an electrical signal into a mechanical stimulus (e.g., a vibration or a movement) or electrical stimulus which may be recognized by a user via his tactile sensation or kinesthetic sensation. According to an embodiment, the haptic module 2179 may include, for example, a motor, a piezoelectric element, or an electric stimulator.

The camera module 2180 may capture a still image or moving images. According to an embodiment, the camera module 2180 may include one or more lenses, image sensors, image signal processors, or flashes.

The power management module 2188 may manage power supplied to the electronic device 2101. According to one embodiment, the power management module 2188 may be implemented as at least part of, for example, a power management integrated circuit (PMIC).

The battery 2189 may supply power to at least one component of the electronic device 2101. According to an embodiment, the battery 2189 may include, for example, a primary cell which is not rechargeable, a secondary cell which is rechargeable, or a fuel cell.

The communication module 2190 may support establishing a direct (e.g., wired) communication channel or a wireless communication channel between the electronic device 2101 and the external electronic device (e.g., the electronic device 2102, the electronic device 2104, or the server 2108) and performing communication via the established communication channel. The communication module 2190 may include one or more communication processors that are operable independently from the processor 2120 (e.g., the application processor (AP)) and supports a direct (e.g., wired) communication or a wireless communication. According to an embodiment, the communication module 2190 may include a wireless communication module 2192 (e.g., a cellular communication module, a short-range wireless communication module, or a global navigation satellite system (GNSS) communication module) or a wired communication module 2194 (e.g., a local area network (LAN) communication module or a power line communication (PLC) module). A corresponding one of these communication modules may communicate with the external electronic device via the first network 2198 (e.g., a short-range communication network, such as BluetoothTM, wireless-fidelity (Wi-Fi) direct, or infrared data association (IrDA)) or the second network 2199 (e.g., a long-range communication network, such as a legacy cellular network, a 5G network, a next-generation communication network, the Internet, or a computer network (e.g., LAN or wide area network (WAN)). These various types of communication modules may be implemented as a single component (e.g., a single chip), or may be implemented as multi components (e.g., multi chips) separate from each other. The wireless communication module 2192 may identify and authenticate the electronic device 2101 in a communication network, such as the first network 2198 or the second network 2199, using subscriber information (e.g., international mobile subscriber identity (IMSI)) stored in the subscriber identification module 2196.

The wireless communication module 2192 may support a 5G network, after a 4G network, and next-generation communication technology, e.g., new radio (NR) access technology. The NR access technology may support enhanced mobile broadband (eMBB), massive machine type communications (mMTC), or ultra-reliable and low-latency communications (URLLC). The wireless communication module 2192 may support a high-frequency band (e.g., the mmWave band) to achieve, e.g., a high data transmission rate. The wireless communication module 2192 may support various technologies for securing performance on a high-frequency band, such as, e.g., beamforming, massive multiple-input and multiple-output (massive MIMO), full dimensional MIMO (FD-MIMO), array antenna, analog beam-forming, or large scale antenna. The wireless communication module 2192 may support various requirements specified in the electronic device 2101, an external electronic device (e.g., the electronic device 2104), or a network system (e.g., the second network 2199). According to an embodiment, the wireless communication module 2192 may support a peak data rate (e.g., 20Gbps or more) for implementing eMBB, loss coverage (e.g., 164dB or less) for implementing mMTC, or U-plane latency (e.g., 0.5ms or less for each of downlink (DL) and uplink (UL), or a round trip of 1ms or less) for implementing URLLC.

The antenna module 2197 may transmit or receive a signal or power to or from the outside (e.g., the external electronic device) of the electronic device 2101. According to an embodiment, the antenna module 2197 may include an antenna including a radiating element composed of a conductive material or a conductive pattern formed in or on a substrate (e.g., a printed circuit board (PCB)). According to an embodiment, the antenna module 2197 may include a plurality of antennas (e.g., array antennas). In such a case, at least one antenna appropriate for a communication scheme used in the communication network, such as the first network 2198 or the second network 2199, may be selected, for example, by the communication module 2190 (e.g., the wireless communication module 2192) from the plurality of antennas. The signal or the power may then be transmitted or received between the communication module 2190 and the external electronic device via the selected at least one antenna. According to an embodiment, another component (e.g., a radio frequency integrated circuit (RFIC)) other than the radiating element may be additionally formed as part of the antenna module 2197.

According to various embodiments, the antenna module 2197 may form a mmWave antenna module. According to an embodiment, the mmWave antenna module may include a printed circuit board, a RFIC disposed on a first surface (e.g., the bottom surface) of the printed circuit board, or adjacent to the first surface and capable of supporting a designated high-frequency band (e.g., the mmWave band), and a plurality of antennas (e.g., array antennas) disposed on a second surface (e.g., the top or a side surface) of the printed circuit board, or adjacent to the second surface and capable of transmitting or receiving signals of the designated high-frequency band.

At least some of the above-described components may be coupled mutually and communicate signals (e.g., commands or data) therebetween via an inter-peripheral communication scheme (e.g., a bus, general purpose input and output (GPIO), serial peripheral interface (SPI), or mobile industry processor interface (MIPI)).

According to an embodiment, commands or data may be transmitted or received between the electronic device 2101 and the external electronic device 2104 via the server 2108 coupled with the second network 2199. Each of the electronic devices 2102 or 2104 may be a device of a same type as, or a different type, from the electronic device 2101. According to an embodiment, all or some of operations to be executed at the electronic device 2101 may be executed at one or more of the external electronic devices 2102, 2104, or 2108. For example, if the electronic device 2101 should perform a function or a service automatically, or in response to a request from a user or another device, the electronic device 2101, instead of, or in addition to, executing the function or the service, may request the one or more external electronic devices to perform at least part of the function or the service. The one or more external electronic devices receiving the request may perform the at least part of the function or the service requested, or an additional function or an additional service related to the request, and transfer an outcome of the performing to the electronic device 2101. The electronic device 2101 may provide the outcome, with or without further processing of the outcome, as at least part of a reply to the request. To that end, a cloud computing, distributed computing, mobile edge computing (MEC), or client-server computing technology may be used, for example. The electronic device 2101 may provide ultra low-latency services using, e.g., distributed computing or mobile edge computing. In another embodiment, the external electronic device 2104 may include an internet-of-things (IoT) device. The server 2108 may be an intelligent server using machine learning and/or a neural network. According to an embodiment, the external electronic device 2104 or the server 2108 may be included in the second network 2199. The electronic device 2101 may be applied to intelligent services (e.g., smart home, smart city, smart car, or healthcare) based on 5G communication technology or IoT-related technology.

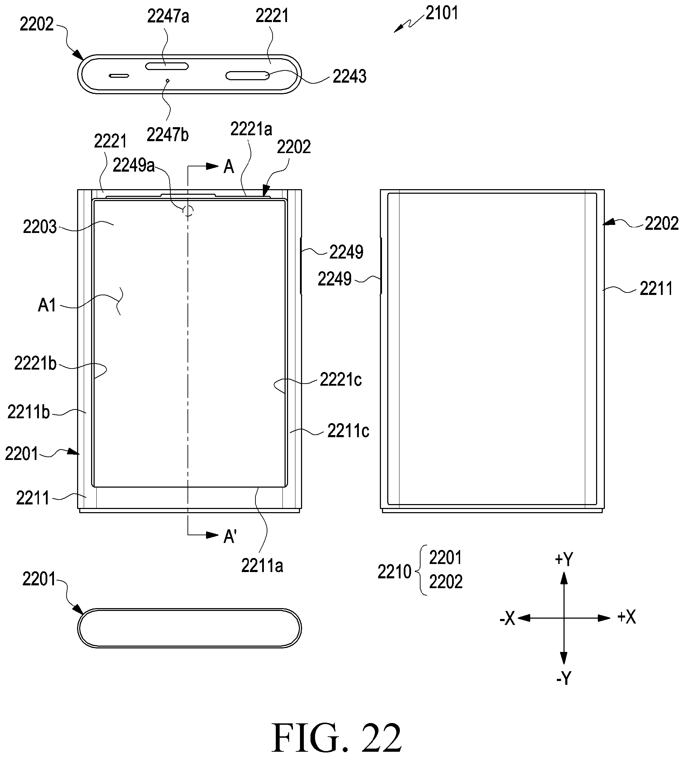

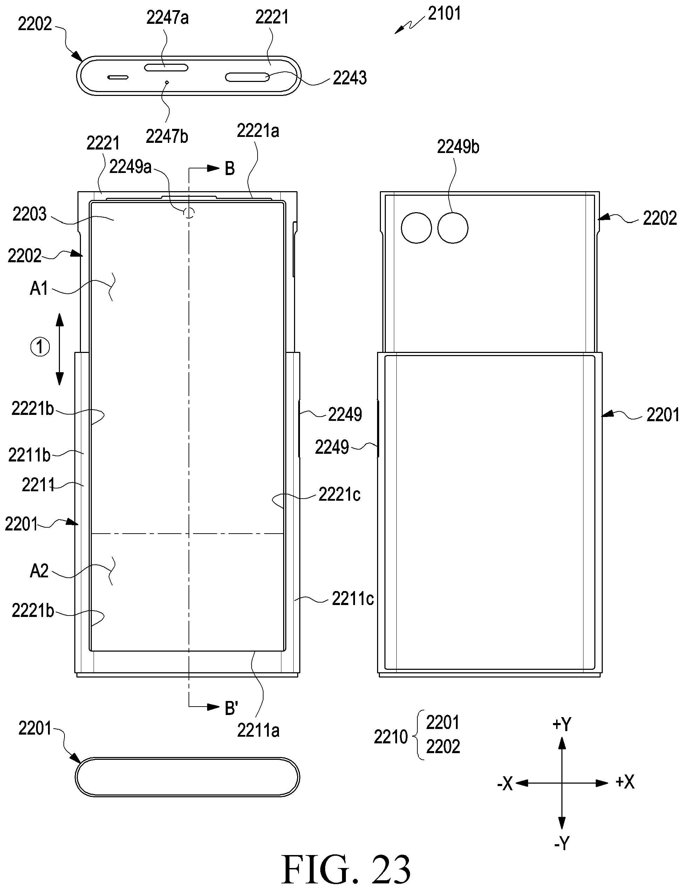

FIG. 22 is a diagram illustrating a state in which a second display area of a display is accommodated in a housing according to various embodiments. FIG. 23 is a diagram illustrating a state in which the second display area of the display is exposed to the outside of the housing according to various embodiments.

FIGS. 22 and 23 illustrate a structure in which a display 2203 (e.g., a flexible display or a rollable display) extends in a longitudinal direction (e.g., a +Y direction), when viewed from the front of the electronic device 2101. However, the extension direction of the display 2203 is not limited to one direction (e.g., the +Y direction). For example, the design may be modified such that the display 2203 is extendable upward (the +Y direction), to the right (e.g., +X direction), to the left (e.g., -X direction), and/or downward (e.g., -Y direction).

The state illustrated in FIG. 22 may be referred to as a closed state ofthe electronic device 2101 or a housing 2210, and a slide-in state(or a fully inserted state) of the display 2203.

The state illustrated in FIG. 23 may be referred to as an open state of the electronic device 2101 or the housing 2210, and a slide-out state (or a fully extended, or fully exposed state) of the display 2203.

Referring to FIGS. 22 and 3, the electronic device 101 may include the housing 2210. The housing 2210 may include a first housing 2201 and a second housing 2202 disposed to be movable relatively with respect to the first housing 2201. It will be appreciated that, in some embodiments, the first housing 2201 may correspond to the second structure 120 of FIGS. 1A to 1C, and the second hosing 2202 may correspond to the first structure 110 of FIGS. 1A to 1C.In some embodiments, this configuration may be interpreted as a structure in which the first housing 2201 is disposed to be slidable (or otherwise moveable) with respect to the second housing 2202 in the electronic device 2101. According to an embodiment, the second housing 2202 may be disposed to reciprocate with respect to the first housing 2201 by or up to a predetermined distance in illustrated directions, for example, directions indicated by arrows CD.

According to various embodiments, the second housing 2202 may be referred to asa slide unit or a slide housing, and disposed to be reciprocal with respect to the first housing 2201. According to an embodiment, the second housing 2202 may accommodate various electric and electronic components such as a circuit board or a battery. However, it will be appreciated that, in other embodiments, various ones of the electric and electronic components may instead be accommodated in the first housing 2201, if desired.

According to an embodiment, a motor, a speaker, a SIM socket, and/or a subcircuit board electrically connected to a main circuit board may be disposed in the first housing 2201. The main circuit board with electrical components such as an AP and a CP mounted thereon may be disposed in the second housing 2202.

According to an embodiment, the first housing 2201 may include a first cover member2211 (e.g., a main case). The first cover member 2211 may include a (1-1)^{th} sidewall 2211a, a (1-2)^{th} sidewall 2211b extending from the (1-1)^{th} sidewall 2211a, and a (1-3)^{th} sidewall 2211c extending from the (1-1)^{th} sidewall 2211a and substantially parallel to the (1-2)^{th} sidewall 2211b. According to an embodiment, the (1-2)^{th} sidewall 2211b and the (1-3)^{th} sidewall 2211c may be formed to be substantially perpendicular to the (1-1)^{th} sidewall 2211a.

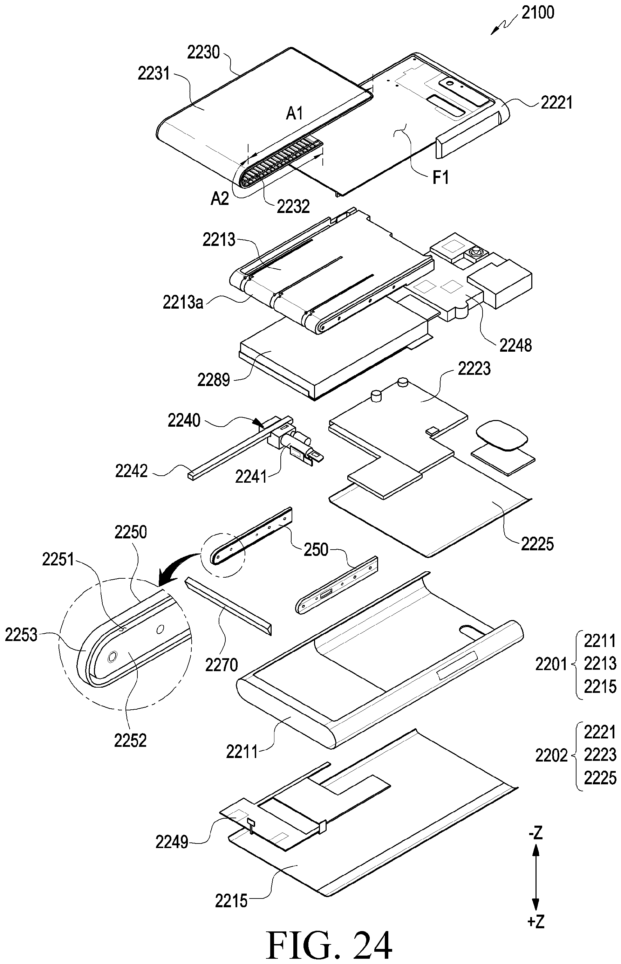

According to various embodiments, the (1-1)^{th} sidewall 2211a, the (1-2)^{th} sidewall 2211b, and the (1-3)^{th} sidewall 2211c of the first cover member 2211 may be formed into a shape open at a portion (e.g., a front surface) thereof to accommodate (or surround) at least part of the second housing 2202. For example, the second housing 2202 may be at least partially surrounded by the first housing 2201 and make a sliding movement in directions parallel to a first surface (e.g., a first surface F1 of FIG. 24), for example, in the directions indicated by the arrows ① under the guidance of the first housing 2201. According to an embodiment, the (1-1)^{th} sidewall 2211a, the (1-2)^{th} sidewall 2211b, and/or the (1-3)^{th} sidewall 2211c may be integrally formed. According to an embodiment, the (1-1)^{th} sidewall 2211a, the (1-2)^{th} sidewall 2211b, and/or the (1-3)^{th} sidewall 2211c may be formed as separate structures to be combined or assembled.

According to various embodiments, the first cover member 2211 may be formed to surround at least part of the display 2203. For example, the at least part of the display 2203 may be formed to be surrounded by the (1-1)^{th} sidewall 2211a, the (1-2)^{th} sidewall 2211b, and the (1-3)^{th} sidewall 2211c of the first cover member 2211.

According to various embodiment, the second housing 2202 may include a second cover member 2221 (a slide plate). The second cover 2221 may be in the form of a plate and include the first surface (e.g., the first surface F1 of FIG. 24) supporting internal components. For example, the second cover member 2221 may support at least part (e.g., a first display area A1) of the display 2203. According to an embodiment, the second cover member 2221 may also be referred to as a front cover.

According to an embodiment, the second cover member 2221 may include a (2-1)^{th} sidewall 2221a, a (2-2)^{th} sidewall 2221b extending from the (2-1)^{th} sidewall 2221a, and a (2-3)^{th} sidewall 2221c extending from the (2-1)^{th} sidewall 2221a and substantially parallel to the (2-2)^{th} sidewall 2221b. According to an embodiment, the (2-2)^{th} sidewall 2221b and the (2-3)^{th} sidewall 2221c may be formed to be substantially perpendicular to the (2-1)^{th} sidewall 2221a.

According to various embodiments, as the second housing 2202 moves in first directions (e.g., the directions ①) parallel to the (1-2)^{th} sidewall 2221b or the (1-2)^{th} sidewall 2211c, the housing 2210 may be placed in the open state and the closed state. The second housing 2201 may be located at a first distance from the (1-1)^{th} sidewall 2211a in the closed state and at a second distance larger than the first distance from the (1-1)^{th} sidewall 22221a in the open state. In some embodiments, the first housing 2201 may surround part of the (2-1)^{th} sidewall 2221a in the closed state.

According to various embodiments, the electronic device 2101 may include the display 2203, key input devices 2245, a connector hole 2243, audio modules 2247a and 2247b, or camera modules 2249a and 2249b. According to an embodiment, the electronic device 2101 may further include an indicator (e.g., a light emitting diode (LED) device) or various sensor modules.

According to various embodiments, the display 2203 may include the first display area A1 and a second display area A2 configured to be exposed to the outside of the electronic device 2101 based on sliding movement of the second housing 2202. According to an embodiment, the first display area A1 may be disposed on the second housing 22022. For example, the first display area A1 may be disposed on the second cover member 2221 of the second housing 2202. According to an embodiment, the second display area A22 may extend from the first display area A1 and be accommodated into the first housing 2201 (e.g., a slide-in state) or visually exposed to the outside of the electronic device 2101 (e.g., a slide-out state), according to the sliding movement of the second housing 2202 with respect to the first housing 2201.

According to various embodiments, the second display area A22 may move substantially under the guidance of an area (e.g., a curved surface 2213a of FIG. 24) of the first housing 2201 to be accommodated into an internal space of the first housing 2201 or exposed to the outside of the electronic device 2101. According to an embodiment, the second display area A22 may move based on the sliding movement of the second housing 2202 in the first directions (e.g., the directions indicated by the arrows CD). For example, while the second housing 2202 is making a sliding movement, part of the second display area A22 may be deformed into a curved surface at a position corresponding to the curved surface 2213a of the first housing 2201.

According to various embodiments, when the housing 2210 is changed from the closed state to the open state (e.g., when the second housing 2201 slidingly moves to extend from the first housing 2201, the second display area A22 may form substantially a flat surface with the first display area A1, while being exposed gradually to the outside of the first housing 2201, when viewed from above the second cover member 2221 (e.g., a front cover). According to an embodiment, the display 2203 may be coupled with or disposed adjacent to a touch sensing circuit, a pressure sensor capable of measuring the intensity (pressure) of a touch, and/or a digitizer that detects a magnetic field type stylus pen. According to an embodiment, part of the exposed second display area A22 may be disposed on part (e.g., the curved surface 2213a of FIG. 24) of the first housing, and kept in the form of a curved surface at a position corresponding to the curved surface 2213a, regardless of whether the housing 2210 is in the closed state or the open state.

According to an embodiment, the key input devices 2245 may be located in one area of the first housing 2201. Depending on the appearance and use state, the electronic device 2101 may be designed to be without the illustrated key input devices 2245 or to include additional key input device(s). According to an embodiment, the electronic device 2101 may include a key input device which is not shown, for example, a home key button or a touch pad disposed around the home key button. According to an embodiment, at least some of the key input devices 2245 may be disposed on the (1-1)^{th} sidewall 2211a, the (1-2)^{th} sidewall 2211b, and/or the (1-3)^{th} sidewall 2211c of the first housing 2201.

According to various embodiments, the connector hole 2243 may be omitted in some embodiments, and may accommodate a connector (e.g., a USB connector) for transmitting and receiving power and/or data to and from an external electronic device. While not shown, the electronic device 2101 may include a plurality of connector holes 2243, and some of the plurality of connector holes 2243 may function as connector holes for transmitting and receiving audio signals to and from an external electronic device. While the connector hole 2243 is disposed in the second housing 2202 in the illustrated embodiment, the disclosure is not limited thereto, and the connector hole 2243 or a connector hole which is not shown may be disposed in the first housing 2201.

According to various embodiments, the audio modules 2247a and 2247b may include at least one speaker hole 2247a or at least one microphone hole 2247b. One of the speaker holes 2247a may be provided as a receiver hole for a voice call, and another one may be provided as an external speaker hole. The electronic device 2101 may include a microphone for obtaining sound, and the microphone may obtain sound from the outside of the electronic device 2101 through the microphone hole 2247b. According to an embodiment, the electronic device 2101 may include a plurality of microphones to detect the direction of sound. According to an embodiment, the electronic device 2101 may include an audio module in which the speaker hole 2247a and the microphone hole 2247b are implemented as a single hole, or a speaker (e.g., a piezo speaker) without the speaker hole 2247a.

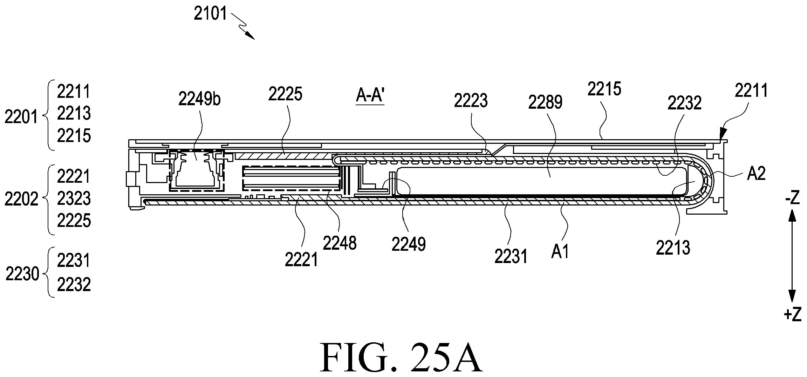

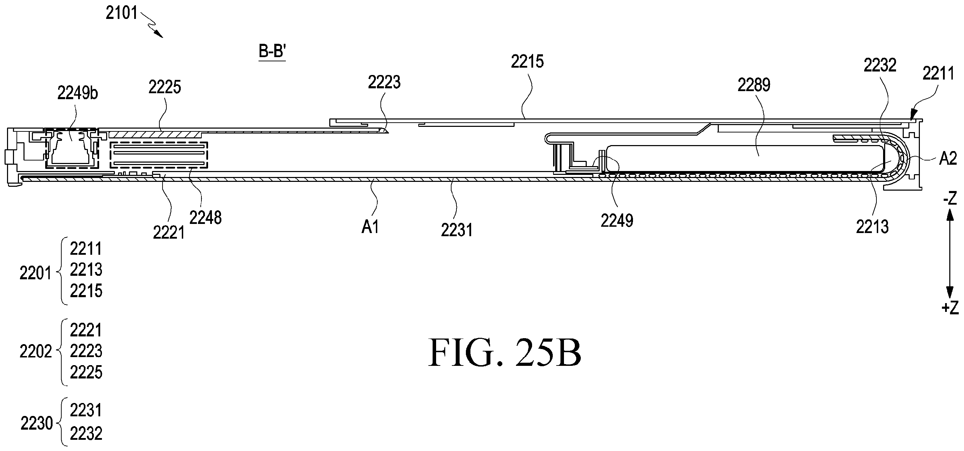

According to various embodiments, the camera modules 2249a and 2249b may include a first camera module 2249a (e.g., a front camera) and a second camera module 2249b (e.g., a rear camera) (e.g., the second camera module 2249b of FIGS. 25A and 25B). According to an embodiment, the electronic device 2101 may include at least one of a wide-angle camera, a telephoto camera, or a close-up camera, and according to an embodiment, may include an IR projector and/or an IR receiver to measure a distance to a subject. The camera modules 2249a and 2249b may include one or more lenses, an image sensor, and/or an image signal processor. The first camera module 2249a may be disposed to face the same direction as the display 2203. For example, the first camera module 2249a may be disposed around the first display area A1 or in an area overlapping with the display 2203, and when disposed in the area overlapping with the display 2203, the first camera module 2249a may capture the subject through the display 2203. According to an embodiment, the first camera module 2249a may include an under display camera (UDC) hidden without being visually exposed from a view area (e.g., the first display area A1). According to an embodiment, the second camera module 2249b may capture a subject in the opposite direction of the first display area A1 of the display 2203. According to an embodiment, the first camera module 2249a and/or the second camera module 2249b may be disposed on the second housing 2202.

According to various embodiments, an indicator (not shown) of the electronic device 2101 may be disposed in the first housing 2201 or the second housing 22022, and include an LED to provide state information about the electronic device 2101 as a visual signal. A sensor module (not shown) of the electronic device 2101 may generate an electrical signal or data value corresponding to an internal operating state of the electronic device 2101 or an external environmental state. The sensor module may include, for example, a proximity sensor, a fingerprint sensor, or a biometric sensor (e.g., an iris/face recognition sensor or an HRM sensor). In another embodiment, the sensor module may further include, for example, at least one of a gesture sensor, a gyro sensor, a barometric pressure sensor, a magnetic sensor, an acceleration sensor, a grip sensor, a color sensor, an IR sensor, a temperature sensor, a humidity sensor, or an illuminance sensor.

FIG. 24 is an exploded perspective view illustrating an electronic device according to various embodiments.

FIG. 25A is a diagram illustrating a cross section taken along line A-A' of FIG. 22 according to various embodiments.

FIG. 25B is a diagram illustrating a cross section taken along line B-B' of FIG. 23 according to various embodiments.

Referring to FIG. 24, FIG. 25A, and/or FIG. 25B, the electronic device 2101 may include the first housing 2201, the second housing 2202, a display assembly2230, and a driving structure 2240. The configurations of the first housing 2201, the second housing 22022, and the display assembly 2230 of FIG. 24, FIG. 25A, and/or FIG. 25B may be wholly or partially identical to those of the first housing 2201, the second housing 2202, and the display 2203 of FIG. 22 and/or FIG. 23.

According to various embodiments, the first housing 2201 may include the first cover member 2211, a frame 2213, and a first rear plate 2215.

According to various embodiments, the first cover member 2211 may accommodate at least part of the frame 2213, and accommodate a component (e.g., a battery 2289) located on the frame 2213. According to an embodiment, the first cover member 2211 may be formed to surround at least part of the second housing 2202. According to an embodiment, a second circuit board 2249 accommodating an electronic component (e.g., the processor 320 and/or the memory 330 of FIG. 3A) may be connected to the first cover member 2211.

According to various embodiments, the frame 2213 may be connected to the first cover member 2211. For example, the frame 2213 may be connected to the first cover member 2211, and the second housing 2202 may move relative to the first cover member 2211 and/or the frame 2213. According to an embodiment, the frame 2213 may include the curved surface 2213a facing the display assembly 2230.

According to various embodiments, the first rear plate 2215 may substantially form at least part of the exterior of the first housing 2201 or the electronic device 2101. For example, the first rear plate 2215 may be coupled with an outer surface of the first cover member 2211. According to an embodiment, the first rear plate 2215 may provide a decorative effect on the exterior of the electronic device 2101. The first rear plate 2215 may be made of at least one of a metal, glass, a synthetic resin, or ceramic.

According to an embodiment, the second housing 2202 may include the second cover member 2221 (e.g., the second cover member 2221 of FIGS. 22 and 23), a rear cover 2223, and a second rear plate 2225.

According to an embodiment, the second cover member 2221 may be connected to the first housing 2201 through a guide rail 2250 and reciprocate in a direction (e.g., the arrowed directions ① in FIG. 23) under the guidance of the guide rail 2250.

According to various embodiments, the second cover member 2221 may support at least part of the display 2203. For example, the second cover member 2221 may include the first surface F1, and the first display area A1 of the display 2203 may be located substantially on the first surface F 1, thus being kept in the form of a flat plate. According to an embodiment, the second cover member 2221 may be formed of a metal material and/or a non-metal (e.g., polymer) material. According to an embodiment, a first circuit board 2248 accommodating an electronic component (e.g., the processor 120 and/or the memory 130 of FIG. 1) may be connected to the second cover member 2221.

According to various embodiments, the rear cover 2223 may protect a component (e.g., the first circuit board 2248) located on the second cover member 2221. For example, the rear cover 2223 may be connected to the second cover member 2221 and formed to surround at least part of the first circuit board 2248. According to an embodiment, the rear cover 2223 may include an antenna pattern to communicate with an external electronic device. For example, the rear cover 2223 may include a laser direct structuring (LDS) antenna.

According to various embodiments, the second rear plate 2225 may substantially form at least part of the exterior of the second housing 2202 or the electronic device 2101. For example, the second rear plate 2225 may be coupled with an outer surface of the second cover member 2221. According to an embodiment, the second rear plate 2225 may provide a decorative effect on the exterior of the electronic device 2101. The second rear plate 2225 may be made of at least one of a metal, glass, a synthetic resin, or ceramic.

According to various embodiments, the display assembly 2230 may include a display 2231 (e.g., the display 2203 of FIG. 22 and/or FIG. 23 and/or the display of FIGS. 1A to 1C and/or FIG. 3A) andamulti-bar structure 2232. According to an embodiment, the display 2231 may be referred to as a flexible display, a foldable display, and/or a rollable display.

According to an embodiment, the multi-bar structure 2232 may be connected or attached to at least part (e.g., the second displayarea A2) of the display 2231. According to an embodiment, as the second housing 2202 slidingly moves, the multi-bar structure 2232 may move with respect to the first housing 2201. In the closed state (e.g., FIG. 22) of the electronic device 2101, most of the multi-bar structure 2232 may be accommodated in the first housing 2201 and located between the first cover member 2211 and the second cover member 2221. According to an embodiment, at least part of the multi-bar structure 2232 may move in correspondence with the curved surface 2213a located at an edge of the frame2213. According to an embodiment, the multi-bar structure 2232 may be referred to as a display support member or support structure, and may be in the form of one elastic plate.

According to an embodiment, the driving structure 2240 may move the second housing 2202 relative to the first housing 2201. For example, the driving structure 2240 may include a motor 2241 configured to generate a driving force for sliding movement of the housings 2201 and 2202.The driving structure 2240 may include a gear (e.g., a pinion) connected to the motor 2241 and a rack 2242 configured to mesh with the gear.

According to various embodiments, the rack 2242 and the motor 2241 may be located in different housings. According to an embodiment, the motor 2241 may be connected to the second housing 2202, and the rack 2242 may be connected to the first housing 2201. According to another embodiment, the motor 2241 may be connected to the first housing 2201, and the rack 2242 may be connected to the second housing 2202.

According to various embodiments, the first housing 2201 may accommodate the first circuit board 2248 (e.g., a main board). According to an embodiment, a processor, memory, and/or an interface may be mounted onthe first circuit board 2248. The processor may include, for example, at least one of a CPU, an AP, a GPU, an image signal processor, a sensor hub processor, or a CP. According to various embodiments, the first circuit board 2248 may include a flexible printed circuit board type radio frequency cable (FRC). The first circuit board 2248 may be disposed on at least part of the second cover member 2221 and electrically connected to an antenna module and a communication module.

According to an embodiment, the memory may include, for example, volatile memory or non-volatile memory.

According to an embodiment, the interface may include, for example, an HDMI, a USBinterface, an SD card interface, and/or an audio interface. The interface may, for example, electrically or physically connect the electronic device 2101 to an external electronic device, and include a USB connector, an SD card/multimedia card (MMC) connector, or an audio connector.

According to various embodiments, the electronic device 2101 may includethe second circuit board 2249 (e.g., a sub circuit) spaced apart from the first circuit board 2248 (e.g., the main circuit board) within the first housing 2201. The second circuit board 2249 may be electrically connected to the first circuit board 2248 through a connection flexible board. The second circuit board 2249 may be electrically connected to the battery 2289 or an electrical component, such as a speaker and/or a SIM socket, disposed in an end area of the electronic device 2101 to transmit signals and power. According to an embodiment, the second circuit board 2249 may accommodate a wireless charging antenna (e.g., a coil). For example, the battery 2289 may receive power from an external electronic device using the wireless charging antenna. In another example, the battery 2289 may transmit power to an external electronic device, using the wireless charging antenna.

According to various embodiments, the battery 2289, which is a device for supplying power to at least one component of the electronic device 2101, may include a non-rechargeable primary battery, a rechargeable secondary battery, or a fuel cell. The battery 2289 may be disposed integrally inside the electronic device 2101 or detachably from the electronic device 2101. According to an embodiment, the battery 2289 may be formed as one integrated battery or include a plurality of separate batteries. According to an embodiment, the battery 2289 may be locatedin the frame 2213 and slidingly move together with the frame 2213.

According to various embodiments, the guide rail 2250 may guide movement of the multi-bar structure 2232. For example, the multi-bar structure 2232 may slidingly move along a slit 2251 formed in the guide rail 2250. According to an embodiment, the guide rail 2250 may be connected to the first housing 2201. For example, the guide rail 2250 may be connected to the first cover member 2211 and/or the frame 2213. According to an embodiment, the slit 2251 may be referred to as a groove or a recess formed on an inner surface of the guide rail 2250.

According to various embodiments, the guide rail 2250 may provide pressure to the multi-bar structure 2233 based on driving of the motor 2241.

According to an embodiment, when the electronic device 2101 is changed from the closed state to the open state, an inner portion 2252 of the guide rail 2250 may provide pressure to the multi-bar structure 2232. The multi-bar structure 2232 receiving the pressure may move along the slit 2251 of the guide rail 2250, and the second housing 2202 may be changed from the slide-in state to the slide-out state with respect to the first housing 2201. At least part of the display assembly 2230 accommodated between the first cover member 2211 and the frame 2213 may extend toward the front surface.

According to an embodiment, when the electronic device 2101 is changed from the open state to the closed state, an outer portion 2253 of the guide rail 2250 may provide pressure to the bent multi-bar structure 2232. The multi-bar structure 2232 receiving the pressure may move along the slit 2251 of the guide rail 2250, and the second housing 2202 may be changed from the slide-out state to the slide-in state with respect to the first housing 2201. At least part of the display assembly 2230 may be accommodated between the first cover member 2211 and the frame 2213.

Referring to FIG. 25A, when the electronic device 2101 is in the closed state (e.g., fully inserted state or fully accommodated state), at least part of the second housing 2202 may be disposed to be accommodated in the first housing 2201. As the second housing 2202 is disposed to be accommodated in the first housing 2201, the overall volume of the electronic device 2101 may be reduced. According to an embodiment, when the second housing 2202 is accommodated in the first housing 2201, the size of the visually exposed display 2231 (that is, the size of the visually exposed portion of the display 2231) may be minimized. For example, when the second housing 2202 is fully accommodated or fully inserted in the first housing 2201, the first display area A1 of the display 2231 may be visually exposed, whereas the second display area A2 may not be visually exposed. At least part of the second display area A2 may be disposed between the battery 2289 and the rear plates 2215 and 2225.

Referring to FIG. 25B, when the electronic device 2101 is in the open state (e.g., partially extendedstate, partially exposedstate, partially insertedstate, partially accommodatestate, fully extended state or fully exposed state), at least part of the second housing 2202 may protrude from the first housing 2201. As the second housing 2202 protrudes from the first housing 2201, the overall volume of the electronic device 2101 may increase. According to an embodiment, when the second housing 2202 protrudes from the first housing 2201, at least part of the second display area A2 of the display 2231 may be visually exposed to the outside of the electronic device 2101, together with the first display area A1. For example, at least part of the second display area A2 may be visually exposed next to the first display area A1.

According to various embodiments, a method of adjusting a size of a display in an electronic device may include displaying a view of an application on a flexible display, identifying whether a condition for changing the size of the display is satisfied based on attribute information about the view,andwhen the condition is satisfied, providing at least one control button for changing the size of the display.

According to various embodiments, the attribute information about the view may include information about a specified display size in which the view is to be displayed.

According to various embodiments, identifying whether the condition for changing the size of the display is satisfied may include identifying that the condition is satisfied, when the size of the display does not match a specified display size in which the view is to be displayed.

According to various embodiments, the method may further include changing the size of the display in correspondence with the attribute information about the view, based on a user input for selection of the control button.

According to various embodiments, the method may further include, upon completion of changing the size of the display in correspondence with the attribute information about the view, releasing the display of the control button on the display.

According to various embodiments, the method may further include releasing the display of the control button, when a user input to the control button is not identified for a predetermined time.

According to various embodiments, the method may further include, when the condition is satisfied, displaying at least one control button for changing the size of the display in a predetermined area of the display.

According to various embodiments, the method may further include, when the condition is satisfied, providing a visual effect that a predetermined area of the display disappears by rolling away and a control area including at least one control button for changing the size of the display is displayed.

According to various embodiments, the method may further include, when the condition is satisfied, displaying a visual indicator at a boundary of a predetermined area of the display, and displaying a control area including at least one control button for changing the size of the display based on a user input to the visual indicator.

According to various embodiments, the method may further include, when the condition is satisfied, displaying an indicator in a predetermined area of the display, and displaying a control bar for changing the size of the display based on a user input to the indicator.

It will be appreciated that the above-described embodiments may be combined with one another in each and every combination, potentially unless there is a conflict between two embodiments. That is, each and every combination of two or more of the above-described embodiments is envisaged and included within the present disclosure.

The electronic device according to various embodiments may be one of various types of electronic devices. The electronic devices may include, for example, a portable communication device (e.g., a smartphone), a computer device, a portable multimedia device, a portable medical device, a camera, a wearable device, or a home appliance. According to an embodiment of the disclosure, the electronic devices are not limited to those described above.

It should be appreciated that various embodiments of the present disclosure and the terms used therein are not intended to limit the technological features set forth herein to particular embodiments and include various changes, equivalents, or replacements for a corresponding embodiment. With regard to the description of the drawings, similar reference numerals may be used to refer to similar or related elements. It is to be understood that a singular form of a noun corresponding to an item may include one or more of the things, unless the relevant context clearly indicates otherwise. As used herein, each of such phrases as "A or B," "at least one of A and B," "at least one of A or B," "A, B, or C," "at least one of A, B, and C," and "at least one of A, B, or C," may include any one of, or all possible combinations of the items enumerated together in a corresponding one of the phrases. As used herein, such terms as "1st" and "2nd," or "first" and "second" may be used to simply distinguish a corresponding component from another, and does not limit the components in other aspect (e.g., importance or order). It is to be understood that if an element (e.g., a first element) is referred to, with or without the term "operatively" or "communicatively", as "coupled with," "coupled to," "connected with," or "connected to"another element (e.g., a second element), it means that the element may be coupled with the other element directly (e.g., wiredly), wirelessly, or via a third element.

As used in connection with various embodiments of the disclosure, the term "module" may include a unit implemented in hardware, software, or firmware, and may interchangeably be used with other terms, for example, logic, logic block, part, or circuitry. A module may be a single integral component, or a minimum unit or part thereof, adapted to perform one or more functions. For example, according to an embodiment, the module may be implemented in a form of an application-specific integrated circuit (ASIC).

Various embodiments as set forth herein may be implemented as software (e.g., the program 140) including one or more instructions that are stored in a storage medium (e.g., internal memory 136 or external memory 138) that is readable by a machine (e.g., the electronic device 2101). For example, a processor (e.g., the processor 2120) of the machine (e.g., the electronic device 2101) may invoke at least one of the one or more instructions stored in the storage medium, and execute it, with or without using one or more other components under the control of the processor. This allows the machine to be operated to perform at least one function according to the at least one instruction invoked. The one or more instructions may include a code generated by a complier or a code executable by an interpreter. The machine-readable storage medium may be provided in the form of a non-transitory storage medium. Wherein, the term "non-transitory" simply means that the storage medium is a tangible device, and does not include a signal (e.g., an electromagnetic wave), but this term does not differentiate between where data is semi-permanently stored in the storage medium and where the data is temporarily stored in the storage medium.

According to an embodiment, a method according to various embodiments of the disclosure may be included and provided in a computer program product. The computer program product may be traded as a product between a seller and a buyer. The computer program product may be distributed in the form of a machine-readable storage medium (e.g., compact disc read only memory (CD-ROM)), or be distributed (e.g., downloaded or uploaded) online via an application store (e.g., PlayStoreTM), or between two user devices (e.g., smart phones) directly. If distributed online, at least part of the computer program product may be temporarily generated or at least temporarily stored in the machine-readable storage medium, such as memory of the manufacturer's server, a server of the application store, or a relay server.

According to various embodiments, each component (e.g., a module or a program) of the above-described components may include a single entity or multiple entities, and some of the multiple entities may be separately disposed in different components. According to various embodiments, one or more of the above-described components may be omitted, or one or more other components may be added. Alternatively or additionally, a plurality of components (e.g., modules or programs) may be integrated into a single component. In such a case, according to various embodiments, the integrated component may still perform one or more functions of each of the plurality of components in the same or similar manner as they are performed by a corresponding one of the plurality of components before the integration. According to various embodiments, operations performed by the module, the program, or another component may be carried out sequentially, in parallel, repeatedly, or heuristically, or one or more of the operations may be executed in a different order or omitted, or one or more other operations may be added.

According to various embodiments, in a non-volatile storage medium storing instructions, the instructions may be configured to, when executed by an electronic device, cause the electronic device to perform at least one operation. The at least one operation may include displaying a view of an application on a flexible display, identifying whether a condition for changing the size of the display is satisfied based on attribute information about the view, and when the condition is satisfied, providing at least one control button for changing the size of the display.

## Claims

1. An electronic device comprising:
a first housing;
a second housing disposed to be movable with respect to the first housing and overlapping with at least part of the first housing;
at least one processor; and
a flexible display at least partially mounted on a surface of the second housing and at least partially exposed to an outside of the electronic device, wherein part of the flexible display is configured to be inserted into or extended from the first housing according to driving of a driving module of the electronic device,
wherein the at least one processor is configured to:
display an execution screen of an application on the flexible display,
identify whether a size of an exposed portion of the flexible display and a specified size of the flexible display for the execution screen match,
when the size of exposed portion of the flexible display and the specified size of the flexible display do not match, display at least one control button for changing the size of the exposed portion of the flexible display on the flexible display.

2. The electronic device of claim 1, wherein the specified size includes at least one of a size previously stored in a memory of the electronic device corresponding to the execution screen, a size changed more than a specified number of times among a plurality of sizes of the flexible display, or a size changed the most number of times among the plurality of sizes.

3. The electronic device of claim 1, wherein the processor is configured tochange the size of exposed portion to the specifiedsize, based on a user input for selection of the at least one control button.

4. The electronic device of claim 1, wherein the processor is configured to release the display of the at least one control button on the flexible display, upon completion of changing the size of exposed portion.

5. The electronic device of claim 1, wherein the processor is configured to release the display of the at least one control button, when a user input to the at least one control button is not identified for a predetermined time.

6. The electronic device of claim 1, wherein the processor is configured to display the at least one control button for changing the size of exposed portion in a predetermined area of the flexible display.

7. The electronic device of claim 1, wherein the processor is configured to provide a visual effect that a predetermined area of the flexible display disappears by rolling away and a control area including the at least one control button for changing the size of exposed portion is displayed.

8. The electronic device of claim 1, wherein the processor is configured to display a visual indicator at a boundary of a predetermined area of the flexible display, and display a control area including the at least one control button for changing the size of exposed portion based on a user input to the visual indicator.

9. The electronic device of claim 1, wherein the processor is configured to display an indicator in a predetermined area of the flexible display, and display a control bar for changing the size of exposed portion based on a user input to the indicator.

10. A method of adjusting a size of a flexible display in an electronic device, the method comprising:
displaying an execution screen of an application on the flexible display;
identifying whether a size of an exposed portion of the flexible display and a specified size of the flexible display for the execution screen match; and
when the size of exposed portion of the flexible display and the specified size of the flexible display do not match, displaying at least one control button for changing the size of the exposed portion of the flexible display on the flexible display.

11. The method of claim 10, wherein the specified size includes at least one of a size previously stored in a memory of the electronic device corresponding to the execution screen, a size changed more than a specified number of times among a plurality of sizes of the flexible display, or a size changed the most number of times among the plurality of sizes.

12. The method of claim 10, further comprising changing the size of exposed portion to the specified size, based on a user input for selection of the at least one control button.

13. The method of claim 10, further comprising, upon completion of changing the size of exposed portion, releasing the display of the at least one control button on the flexible display.

14. The method of claim 10, further comprising releasing the display of the at least one control button, when a user input to the at least one control button is not identified for a predetermined time.

15. The method of claim 10, further comprising displaying the at least one control button for changing the size of exposed portion in a predetermined area of the flexible display.
